(19) Europäisches Patentamt
European Patent Office
Office européen des brevets

(11) EP 3 330 097 B1

(12) # EUROPEAN PATENT SPECIFICATION

(45) Date of publication and mention of the grant of the patent:
**16.10.2019 Bulletin 2019/42**

(21) Application number: **16832744.3**

(22) Date of filing: **15.07.2016**

(51) Int Cl.:
***G03F 7/032*** *(2006.01)* ***G03F 7/037*** *(2006.01)*
***G03F 7/038*** *(2006.01)* ***G03F 7/30*** *(2006.01)*
*G03F 7/035* *(2006.01)*

(86) International application number:
**PCT/JP2016/071068**

(87) International publication number:
**WO 2017/022465 (09.02.2017 Gazette 2017/06)**

(54) **LITHOGRAPHIC PRINTING ORIGINAL PLATE AND PLATE MAKING METHOD**

ORIGINALFLACHDRUCKPLATTE UND PLATTENHERSTELLUNGSVERFAHREN

PLAQUE ORIGINALE D'IMPRESSION LITHOGRAPHIQUE ET PROCÉDÉ DE FABRICATION DE PLAQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.07.2015 JP 2015152944**

(43) Date of publication of application:
**06.06.2018 Bulletin 2018/23**

(73) Proprietor: **Fujifilm Corporation**
**Minato-ku**
**Tokyo 106-8620 (JP)**

(72) Inventors:
- **INASAKI Takeshi**
  **Shizuoka 421-0396 (JP)**
- **IDEI Hiroaki**
  **Shizuoka 421-0396 (JP)**
- **NOZAKI Atsuyasu**
  **Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A2- 1 564 591** **JP-A- 2001 162 965**
**JP-A- 2008 247 000** **JP-A- 2010 076 436**
**US-A1- 2011 076 621**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

## BACKGROUND OF THE INVENTION

1. Field of the Invention

The present invention relates to a planographic printing plate precursor which is capable of so-called direct plate-making using various lasers from digital signals of a computer and the like; and a plate-making method.

2. Description of the Related Art

A planographic printing plate is typically formed of a lipophilic image area that receives ink and a hydrophilic non-image area that receives dampening water during printing. The planographic printing is a method of performing printing by utilizing a lipophilic image area of a planographic printing plate as an ink receiving portion and a hydrophilic non-image area as a dampening water receiving portion (ink non-receiving portion) using a property that water and oil ink repel each other, causing a difference in adhesiveness in ink on a surface of the planographic printing plate to attach the ink only onto the image area, and transferring the ink to a printing medium such as paper.

Currently, a planographic printing plate is prepared using a computer-to-plate (CTP) technology. That is, a planographic printing plate precursor is directly scanned, exposed, and developed using a laser or a laser diode without using a lith film, thereby obtaining a planographic printing plate. Along with this, one task related to the planographic printing plate precursor is to improve image forming properties, printing properties, and physical properties in correspondence with the CTP technology.

Meanwhile, from the growing interest in the global environment, environmental issues related to a waste liquid associated with wet treatments such as a development treatment have been closed up as a problem of a planographic printing plate precursor.

In regard to the above-described environmental issues, it is desired to simplify a development treatment or a plate-making treatment or not to perform a treatment. As one of a simple plate-making method, a method referred to as "on-press development" has been performed. In other words, the on-press development is a method of exposing a planographic printing plate precursor, mounting the planographic printing plate precursor on a printing press as it is without performing a development treatment using a developer of the related art, and then removing an unnecessary portion (non-image area) of an image recording layer, at an initial stage of a typical printing step.

In a case of on-press development in which an unnecessary portion (non-image area) of an image recording layer is removed using dampening water and/or printing ink, developing capacity is extremely low compared to the development treatment using a developer of the related art. Since the lipophilicity of an image area increases in a case where the hydrophilicity of the image recording layer is increased for the purpose of promoting the on-press developability, adhesiveness (ink receptivity) of printing ink to the image area is degraded and printing durability is also degraded. Further, in a case where the lipophilicity of the image recording layer is increased in order to improve the ink receptivity or the printing durability, on-press developability deteriorates. As described above, the on-press developability and the ink receptivity or the printing durability are in a so-called trade-off relationship, and thus it is extremely difficult to satisfy the both at the same time.

In the on-press development, since the development proceeds on a printing press, the removed unnecessary portion (non-image area) of the image recording layer adheres to a roller or the like of the printing press as development scum and this results in degradation of the maintainability of the printing press. The development scum re-adheres to a printing plate so that the quality of a printed material is degraded and further re-adheres to the printed material itself so that contamination is caused. Therefore, it is important to prevent adhesion of development scum.

Various suggestions have been made in order to solve these problems from the related art.

For example, JP2010-76436A describes a planographic printing plate precursor which includes a photopolymerizable layer containing a polymer compound that has a urea bond in a main chain and a hydrophilic group and is capable of performing on-press development. Further, JP2008-247000A describes a planographic printing plate precursor which includes a photopolymerization layer containing a polymer compound that has a sulfonamide group in a side chain and a hydrophilic group and is capable of performing on-press development.

In US 2011/076621 A1 a lithographic printing plate precursor including a support, and an image-recording layer is desribed. The image-recording layer contains a urethane resin having a polyalkylene oxide chain in a side chain, an infrared absorbing agent, a radical polymerizable compound and a radical polymerization initiator; an unexposed area of the image-recording layer is capable of being removed with at least one of dampening water and ink.

Furthermore, it is referred to EP 1 564 591 A2, which discloses a polymerizable composition comprising a non-acrylic binder polymer having an ethylenically unsaturated bond on a side chain, a neutrally charged compound capable of generating a radical under light or heat, and a compound having an ethylenically unsaturated bond; the document

dislcoses the comparative polymer R-3 mentioned later in the present application. The composition is used as image-recording layer of a lithographic printing plate precursor.

## SUMMARY OF THE INVENTION

In the technology described in JP2010-76436A, it was understood that on-press developability is insufficient in some cases even through printing durability, resistance to adhesion of development scum, and ink receptivity are relatively excellent. Further, in the technology described in JP2008-247000A, it was understood that printing durability is insufficient in some cases even through on-press developability, resistance to adhesion of development scum, and ink receptivity are relatively excellent.

As described above, with the technologies of the related art, it was difficult to satisfy all of the on-press developability, the resistance to adhesion of development scum, the ink receptivity, and the printing durability at the same time.

An object of the present invention is to provide a planographic printing plate precursor and a plate-making method in which on-press developability, resistance to adhesion of development scum, ink receptivity, and printing durability are excellent.

1. A planographic printing plate precursor comprising: a support; and an image recording layer on the support, in which the image recording layer contains a polymer having any group selected from a sulfonamide group, an amide group, an imide group and a carbonate group in a main chain and having a group represented by the following Formula (1).

$$(1) \quad -\left[ X-Ra \right]_{n}-$$

In Formula (1), X represents a single bond or an oxygen atom, Ra represents an alkylene group having 6 to 40 carbon atoms in a case where X represents a single bond and Ra represents an alkylene group having 2 to 20 carbon atoms in a case where X represents an oxygen atom, and n represents an integer of 1 to 90.

2. The planographic printing plate precursor according to 1., in which the polymer has the group represented by Formula (1) in the main chain.
3. The planographic printing plate precursor according to 1. or 2., in which the group represented by Formula (1) is an oxyethylene group or an oxypropylene group.
4. The planographic printing plate precursor according to any one of 1. to 3., in which the polymer is a polymer that further has a radical polymerizable reactive group.
5. The planographic printing plate precursor according to any one of 1. to 4., in which a mass average molecular weight of the polymer is in a range of 3000 to 60000.
6. The planographic printing plate precursor according to any one of 1. to 5., in which an acid value of the polymer is 0.05 mEq/g or less.
7. The planographic printing plate precursor according to any one of 1. to 6., in which a proportion of the group represented by Formula (1) in the polymer is in a range of 15% to 60% by mass.
8. The planographic printing plate precursor according to any one of 1. to 7., in which the image recording layer further contains a polymerizable compound, a polymerization initiator, and an infrared-ray absorbent.
9. The planographic printing plate precursor according to any one of 1. to 8., in which an unexposed portion of the image recording layer is removable by at least one of dampening water or printing ink.
10. A plate-making method comprising: image-exposing the planographic printing plate precursor according to 9. using an infrared laser; and removing the unexposed portion of the image recording layer using at least one of dampening water or printing ink on a printing press.

According to the present invention, it is possible to provide a planographic printing plate precursor and a plate-making method in which on-press developability, resistance to adhesion of development scum, ink receptivity, and printing durability are excellent.

## DESCRIPTION OF THE PREFERRED EMBODIMENTS

Hereinafter, the present invention will be described in detail.

[Planographic printing plate precursor]

A planographic printing plate precursor of the present invention includes a support; and an image recording layer, in which the image recording layer contains a polymer having any group selected from a sulfonamide group, an amide group, an imide group and a carbonate group in a main chain and having a group represented by the following Formula (1).

$$(1)\quad -\!\left[X-Ra\right]_n\!-$$

In Formula (1), X represents a single bond or an oxygen atom. Ra represents an alkylene group having 6 to 40 carbon atoms in a case where X represents a single bond and Ra represents an alkylene group having 2 to 20 carbon atoms in a case where X represents an oxygen atom. n represents an integer of 1 to 90.

The planographic printing plate precursor of the present invention may be provided with an undercoat layer between the support and the image recording layer or a protective layer on the image recording layer as necessary.

The image recording layer of the planographic printing plate precursor according to the present invention contains a polymer having any group selected from a sulfonamide group, an amide group, an imide group and a carbonate group in the main chain and having a group represented by Formula (1). With this configuration, the planographic printing plate precursor and a planographic printing plate obtained by plate-making the planographic printing plate precursor are considered to have excellent on-press developability, resistance to adhesion of development scum, ink receptivity, and printing durability.

Hereinafter, constituent elements and the like of the planographic printing plate precursor according to the present invention will be described in detail.

[Image recording layer]

The image recording layer of the planographic printing plate precursor according to the present invention contains a polymer having any group selected from a sulfonamide group, an amide group, an imide group and a carbonate group in the main chain and having a group represented by Formula (1) (hereinafter, also referred to as a "polymer according to the present invention" or a "specific polymer").

<Specific polymer>

The specific polymer contained in the image recording layer of the planographic printing plate precursor according to the present invention is a polymer that has any group selected from a sulfonamide group, an amide group, an imide group and a carbonate group in the main chain and has a group represented by Formula (1).

The specific polymer has any group selected from a sulfonamide group, an amide group, an imide group and a carbonate group in the main chain and has the group represented by Formula (1) in the main or side chain.

The sulfonamide group, the amide group, the imide group, or the carbonate group contained in the main chain of the specific polymer are respectively represented by the following structures. In the following structures, the hydrogen atom may be substituted with an arbitrary substituent.

Sulfonamide group: $-SO_2NH-$
Amide group: -CONH-
Imide group: -CO-NH-CO-
Carbonate group: -O-CO-O-

Here, the main chain indicates an atomic group (hereinafter, referred to as an atomic group A) that connects both terminals of a polymer with the shortest number of atoms. The expression "having any group selected from a sulfonamide group, an amide group, an imide group and a carbonate group in the main chain" means that at least one atom constituting these groups is included in the atomic group A.

For example, in a polymer (A) and a polymer (B) shown below, portions (atomic group A) corresponding to the

main chains are indicated by bold lines. In the polymer (A), S atoms and N atoms of the sulfonamide group are included in the atomic group A, and the polymer (A) is a polymer containing a sulfonamide group in the main chain. In addition, the polymer (B) contains an imide group, but this imide group is present in the side chain and is not included in the atomic group A. Therefore, the polymer (B) is not a polymer containing an imide group in the main chain.

Polymer (A)

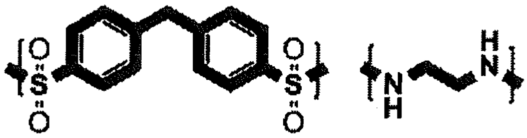

Polymer (B)

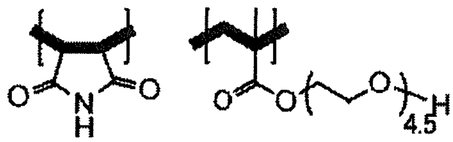

The content of any group selected from a sulfonamide group, an amide group, an imide group and a carbonate group in the specific polymer is preferably in a range of 1.0 to 9.0 mmol, more preferably in a range of 1.5 to 7.0 mmol, and particularly preferably in a range of 2.0 to 5.0 mmol per 1 g of the solid content in the specific polymer.

The specific polymer may contain other groups in the main chain in addition to the sulfonamide group, the amide group, the imide group, and the carbonate group. Examples of other groups which may be contained in the main chain include a carbamate group, an ester group, and a urea group, and these groups are respectively represented by the following structures. In the following structures, the hydrogen atom may be substituted with an arbitrary substituent.

Carbamate group: -O-CO-NH-

Ester group: -CO-O-

Urea group: -NH-CO-NH-

The content of other groups which may be contained in the main chain is preferably in a range of 1.0 to 9.0 mmol, more preferably in a range of 1.5 to 7.0 mmol, and particularly preferably in a range of 2.0 to 5.0 mmol per 1 g of the solid content in the specific polymer.

The specific polymer further contains a group represented by Formula (1).

$$(1)\quad \left[ X-Ra \right]_n$$

In Formula (1), X represents a single bond or an oxygen atom. Ra represents an alkylene group having 6 to 40 carbon atoms in a case where X represents a single bond and Ra represents an alkylene group having 2 to 20 carbon atoms in a case where X represents an oxygen atom. n represents an integer of 1 to 90.

In the case where X represents a single bond, the number of carbon atoms in the alkylene group represented by Ra is preferably in a range of 6 to 30, more preferably in a range of 6 to 20, and particularly preferably in a range of 6 to 12. It is preferable that n represents 1. In the case where X represents an oxygen atom, the number of carbon atoms in the alkylene group represented by Ra is preferably in a range of 2 to 8, more preferably in a range of 2 to 6, and particularly preferably in a range of 2 to 4. n represents preferably an integer of 2 to 90, more preferably an integer of 6 to 60, and particularly preferably an integer of 9 to 45.

Among examples of the group represented by Formula (1), from the viewpoint of excellent balance between the on-press developability and the printing durability, an oxyethylene group and an oxypropylene group are particularly preferable.

The specific polymer may contain a plurality of groups represented by Formula (1) which have different structures. It is preferable that the groups represented by Formula (1) are contained in the main chain of the specific polymer.

The content of the group represented by Formula (1) in the specific polymer is preferably in a range of 10% to 90% by mass, more preferably in a range of 15% to 70% by mass, and particularly preferably in a range of 15% to 60% by mass.

From the viewpoint of further improvement of the on-press developability, the acid value of the specific polymer is preferably 0.05 mEq/g or less. Here, the acid value indicates the equivalent of acidic protons contained in 1 g of the solid content of the specific polymer.

In order to further improve the coated-film characteristics, ink receptivity, on-press developability, and printing durability of the image recording layer, it is also preferable that the specific polymer contains a radical polymerizable reactive group. In a case where the specific polymer contains a radical polymerizable reactive group, an image area

reacts with a polymerizable compound such as a monomer contained in the image recording layer so that the printing durability can be sufficiently ensured. Further, in a non-image area, the flexibility increases because of the radical polymerizable reactive group being contained in the specific polymer so that the on-press developability of an unexposed portion can be improved. It is preferable that the radical polymerizable reactive group is introduced into a side chain or a terminal of the specific polymer and more preferable that the radical polymerizable reactive group is introduced into both of a side chain and a terminal of the specific polymer.

As the radical polymerizable reactive group, a group represented by any of Formulae (1) to (3) is preferable.

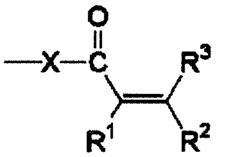 (1) 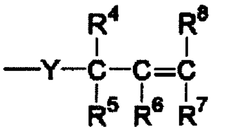 (2) 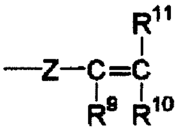 (3)

In Formulae (1) to (3), X and Y each independently represent an oxygen atom, a sulfur atom, or -N($R^{12}$)-. Z represents an oxygen atom, a sulfur atom, -N($R^{12}$)-, or a phenylene group. $R^1$ to $R^{12}$ each independently represent a hydrogen atom or a monovalent substituent.

In Formula (1), $R^1$ to $R^3$ each independently represent a hydrogen atom or a monovalent substituent. Specifically, a hydrogen atom or a monovalent organic group such as an alkyl group which may have a substituent is exemplified as $R^1$. Among these, a hydrogen atom, a methyl group, a methylalkoxy group, and a methyl ester group are preferable. Further, $R^2$ and $R^3$ each independently represent a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent. Among these, a hydrogen atom, a carboxyl group, an alkoxycarbonyl group, an alkyl group which may have a substituent, and an aryl group which may have a substituent are preferable. Here, examples of the substituent which can be introduced include a methoxycarbonyl group, an ethoxycarbonyl group, an isopropoxycarbonyl group, a methyl group, an ethyl group, and a phenyl group. X represents an oxygen atom, a sulfur atom, or -N($R^{12}$ )-, and an alkyl group which may have a substituent or a hydrogen atom may be exemplified as $R^{12}$.

In Formula (2), $R^4$ to $R^8$ each independently represent a hydrogen atom or a monovalent substituent. Specifically, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl which may have a substituent, and an arylsulfonyl group which may have a substituent are exemplified as $R^4$ to $R^8$. Among these, a hydrogen atom, a carboxyl group, an alkoxycarbonyl group, an alkyl group which may have a substituent, and an aryl group which may have a substituent are preferable. Examples of the substituent which can be introduced include those exemplified in Formula (1). Y represents an oxygen atom, a sulfur atom, or -N($R^{12}$)-. Examples of $R^{12}$ include those exemplified in Formula (1).

In Formula (3), $R^9$ to $R^{11}$ each independently represent a hydrogen atom or a monovalent substituent. Specifically, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl which may have a substituent, and an arylsulfonyl group which may have a substituent are exemplified as $R^9$ to $R^{11}$. Among these, a hydrogen atom, a carboxyl group, an alkoxycarbonyl group, an alkyl group which may have a substituent, and an aryl group which may have a substituent are preferable. Examples of the substituent which can be introduced include those exemplified in Formula (1). Z represents an oxygen atom, a sulfur atom, -N($R^{12}$)-, or a phenylene group. Examples of $R^{12}$ include those exemplified in Formula (1).

Among the groups represented by Formulae (1) to (3), a (meth)acryloyloxy group represented by Formula (1) is preferable.

In a case where a radical polymerizable reactive group is introduced in the specific polymer, from the viewpoints of excellent sensitivity and excellent storage stability, the content thereof is preferably in a range of 0.1 to 10.0 mmol, more preferably in a range of 0.5 to 7.0 mmol, and particularly preferably in a range of 1.0 to 3.0 mmol per 1 g of the solid content in the specific polymer.

The mass average molecular weight (Mw) of the specific polymer is preferably 3,000 or greater, more preferably

in a range of 3,000 to 300,000, still more preferably in a range of 3000 to 100000, and particularly preferably in a range of 3000 to 60000. From the viewpoints of excellent printing durability and the on-press developability, it is preferable that the mass average molecular weight thereof is in the above-described range. The mass average molecular weight (Mw) is a value in terms of polystyrene which is obtained according to a gel permeation chromatography (GPC) method.

Further, the specific polymer may include unreacted monomers. In this case, the proportion of monomers in the specific polymer is desirably 15% by mass or less.

The specific polymer can be used alone or in combination of two or more kinds thereof so as to be used for the image recording layer.

From the viewpoints of excellent image area strength and image formability, the content of the specific polymer is preferably in a range of 5% to 80% by mass, more preferably in a range of 5% to 50% by mass, and particularly preferably in a range of 5% to 30% by mass with respect to the total solid content of the image recording layer.

The specific polymer can be synthesized using a known method. A polymer containing a sulfonamide group in the main chain can be synthesized using, for example, a method of synthesizing polysulfonamide described in WO2006/059700A. A polymer containing an amide group in the main chain can be synthesized using, for example, a method of synthesizing polyamide described in JP2011-123219A. A polymer containing an imide group in the main chain can be synthesized using, for example, any method of synthesizing polyimide described in WO2010/126133A and WO2010/071100A. A polymer containing a carbonate group in the main chain can be synthesized using, for example, a method of synthesizing polycarbonate described in WO2010/150885A. Further, polyurethane or polyester can be synthesized as a polyurethane-polycarbonate composite polymer or a polyester-polycarbonate composite polymer by synthesizing polyurethane or polyester using commercially available products of polycarbonate diol as raw materials.

Specific examples of the specific polymer contained in the image recording layer of the planographic printing plate precursor according to the present invention will be shown in the examples below, but the present invention is not limited to these.

It is preferable that the image recording layer of the planographic printing plate precursor according to the present invention contains a polymerizable compound, a polymerization initiator, and an infrared-ray absorbent in addition to the above-described specific polymer.

<Polymerizable compound>

The image recording layer contains a polymerizable compound. The polymerizable compound is an addition polymerizable compound having at least one ethylenic unsaturated double bond and the polymerizable compound is selected from compounds having at least one and preferably two or more terminal ethylenic unsaturated bonds. The polymerizable compounds have chemical forms such as a monomer, a pre-polymer, that is, a dimer, a trimer, an oligomer, and a mixture of these. Examples of the monomer include unsaturated carboxylic acid (such as acrylic acid, methacrylic acid, itaconic acid, crotonic acid, isocrotonic acid, or maleic acid), esters, and amides thereof. Among these, esters of unsaturated carboxylic acid and a polyhydric alcohol compound and amides of unsaturated carboxylic acid and a polyvalent amine compound are preferably used. Further, addition reactants with unsaturated carboxylic acid ester having a nucleophilic substituent such as a hydroxyl group, an amino group, or a mercapto group or amides and monofunctional or polyfunctional isocyanates or epoxies; and dehydration condensation reactants with monofunctional or polyfunctional carboxylic acid are suitably used. Moreover, addition reactants with unsaturated carboxylic acid esters having an electrophilic substituent such as an isocyanate group or an epoxy group or amides and monofunctional or polyfunctional alcohols, amines, or thiols; and substitution reactants with unsaturated carboxylic acid esters having a releasable substituent such as a halogen group or a tosyloxy group or amides and monofunctional or polyfunctional alcohols, amines, or thiols are also suitably used. Further, compound groups in which the above-described unsaturated carboxylic acid is replaced with unsaturated phosphonic acid, styrene, vinyl ether, and the like can also be used. These are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, and JP1998-333321A (JP-H10-333321A).

Specific examples of monomers of esters of a polyhydric alcohol compound and unsaturated carboxylic acid include acrylic acid ester such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, or a polyester acrylate oligomer. Examples of the methacrylic acid ester include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane, and bis-[p-(methacryloxyethoxy)phenyl]dimethylmethane. Specific examples of monomers of amides of a polyvalent amine compound and unsaturated carboxylic acid include methylene bis-acrylamide, methylene bis-methacrylamide, 1,6-hexamethylene bis-acrylamide, 1,6-hexamethylene bis-methacrylamide, diethylene triamine trisacrylamide, xylylene bisacrylamide, and xylylene bismethacrylamide.

Moreover, a urethane-based addition polymerizable compound produced by using an addition reaction of isocyanate and a hydroxyl group is also suitable, and specific examples such a compound include a vinyl urethane compound which is formed by adding a vinyl monomer containing a hydroxyl group represented by the following Formula (P) to a polyisocyanate compound that has two or more isocyanate groups in one molecule described in JP 1973-41708B (JP-S48-41708B) and contains two or more polymerizable vinyl groups in one molecule.

$$CH_2=C(R^{104})COOCH_2CH(R^{105})OH \qquad (P)$$

(Here, $R^{104}$ and $R^{105}$ represent H or $CH_3$.)

In addition, urethane acrylates described in JP1976-37193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also preferable.

Among the examples described above, from the viewpoint that the balance between hydrophilicity associated with on-press developability and polymerization ability associated with printing durability is excellent, isocyanuric acid ethylene oxide-modified acrylates such as tris(acryloyloxyethyl) isocyanurate and bis(acryloyloxyethyl)hydroxyethyl isocyanurate are particularly preferable in a case of a planographic printing plate precursor to which on-press development is applied.

The details of the structures of these polymerizable compounds, whether to be used alone or in combination, and the usage method such as the addition amount can be arbitrarily set according to the final performance design of the planographic printing plate precursor. The content of the above-described polymerizable compound is preferably in a range of 5% to 75% by mass, more preferably in a range of 25% to 70% by mass, and still more preferably in a range of 30% to 60% by mass with respect to the total solid content of the image recording layer.

<Polymerization initiator>

The image recording layer contains a polymerization initiator. In the present invention, a radical polymerization initiator is preferably used.

As the polymerization initiator, compounds known to those skilled in the art can be used without limitation, and specific examples thereof include a trihalomethyl compound, a carbonyl compound, an organic peroxide, an azo compound, an azide compound, a metallocene compound, a hexaarylbiimidazole compound, an organoboron compound, a disulfone compound, an oxime ester compound, an onium salt, and an iron arene complex. Among these, at least one selected from the group consisting of a hexaarylbiimidazole compound, an onium salt, a trihalomethyl compound, and a metallocene compound is preferable and a hexaarylbiimidazole compound and an onium salt are particularly preferable.

Examples of the hexaarylbiimidazole compound include lophine dimers described in EP24629B, EP107792B, and US4410621A, such as 2,2-bis(o-chlorophenyl)-4,4',5,5'-tetraphenylbiimidazole, 2,2'-bis(o-bromophenyl)-4,4'5,5'-tetraphenylbiimidazole, 2,2'-bis(o,p-dichlorophenyl)-4,4'5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2' -bis(o-methylphenyl)-4,4',5,5 '-tetraphenylbiimidazole, and 2,2'-bis(o-trifluoromethylphenyl)-4,4',5,5'-tetraphenylbiimidazole. It is particularly preferable that the hexaarylbiimidazole compound is used in combination with a sensitizing coloring agent having the maximum absorption in a wavelength range of 300 to 450 nm.

Examples of the onium salt compound include onium salts such as diazonium salts described in S. I. Schlesinger, Photogr. Sci. Eng., 18, 387 (1974), T. S. Bal et al, Polymer, 21, 423 (1980) and JP1993-158230A (JP-H05-158230A), ammonium salts described in US4069055A and JP1992-365049A (JP-H04-365049A), phosphonium salts described in US4069055A and US4069056A, iodonium salts described in EP104143B, US2008/0311520A, JP1990-150848A (JP-H02-150848A), JP2008-195018A, and J. V. Crivello et al, Macromolecules, 10(6), 1307 (1977), sulfonium salts described in EP370693B, EP233567B, EP297443B, EP297442B, US4933377A, US4760013A, US4734444A, US2833827A, GE2904626B, GE3604580B, and GE3604581B, selenonium salts described in J. V. Crivello et al, J. Polymer Sci., Polymer Chem. Ed., 17, 1047 (1979), arsonium salts described in C. S. Wen et al, Teh, Proc. Conf. Rad. Curing ASIA, p478 Tokyo, Oct (1988), and azinium salts described in JP2008-195018A.

Among these onium salts, iodonium salts, sulfonium salts, and azinium salts are preferable. Hereinafter, specific examples of these compounds will be described, but the present invention is not limited to these.

As the iodonium salts, diphenyliodonium salts are preferable, electron-donating groups such as diphenyl iodonium salts substituted with an alkyl group or an alkoxyl group are particularly preferable, and asymmetric diphenyl iodonium salts are still more preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyliodonium=hexafluorophosphate, 4-hexyloxyphenyl-2,4-diethoxyphenyliodonium=tetrafluoroborate, 4-octyloxyphenyl-2,4,6-trimethoxyphenyliodonium=1-perfluorobutanesulfonate, 4-octyloxyphenyl-2,4,6-trimethoxyphenyliodonium=hexafluorophosphate, and bis(4-t-butylphenyl)iodonium=tetraphenylborate.

Examples of the sulfonium salts include triphenylsulfonium=hexafluorophosphate, triphenylsulfonium=benzoylformate, bis(4-chlorophenyl)phenylsulfonium=benzoylformate, bis(4-chlorophenyl)-4-methylphenylsulfonium=tetrafluoroborate, tris(4-chlorophenyl)sulfonium=3,5-bis(methoxycarbonyl)benzenesulfonate, and tris(4-chlorophenyl)sulfonium=hexafluorophosphate.

Examples of the azinium salts include 1-cyclohexylmethyloxypyridinium=hexafluorophosphate, 1-cyclohexyloxy-4-phenylpyridinium=hexafluorophosphate, 1-ethoxy-4-phenylpyridinium=hexafluorophosphate, 1-(2-ethylhexyloxy)-4-phenylpyridinium=hexafluorophosphate, 4-chloro-1-cyclohexylmethyloxypyridinium=hexafluorophosphate, 1-ethoxy-4-cyanopyridinium=hexafluorophosphate, 3,4-dichloro-1-(2-ethylhexyloxy)pyridinium=hexafluorophosphate, 1-benzyloxy-4-phenylpyridinium=hexafluorophosphate, 1-phenethyloxy-4-phenylpyridinium=hexafluorophosphate, 1-(2-ethylhexyloxy)-4-phenylpyridinium=p-toluenephosphate, 1-(2-ethylhexyloxy)-4-phenylpyridinium=perfluorobutanesulfonate, 1-(2-ethylhexyloxy)-4-phenylpyridinium=bromide, and 1-(2-ethylhexyloxy)-4-phenylpyridinium=tetrafluoroborate.

It is particularly preferable that the onium salts are used in combination with an infrared-ray absorbent having the maximum absorption in a wavelength range of 750 to 1400 nm.

In addition, polymerization initiators described in paragraphs [0071] to [0129] of JP2007-206217A can be preferably used.

The polymerization initiator is used alone or in combination of two or more kinds thereof.

The content of the polymerization initiator is preferably in a range of 0.01% to 20% by mass, more preferably in a range of 0.1% to 15% by mass, and still more preferably in a range of 1.0% to 10% by mass with respect to the total solid content of the image recording layer.

<Infrared-ray absorbent>

The image recording layer contains an infrared-ray absorbent. The infrared-ray absorbent has a function of converting absorbed infrared rays into heat and a function of electron transfer to a polymerization initiator through excitation by infrared rays or a function of energy transfer. As the result, a radical is generated and a polymerization reaction of a polymerizable compound is initiated and promoted so that a cured image is formed. It is preferable that the infrared-ray absorbent has a maximum absorption in a wavelength range of 750 to 1400 nm. As the infrared-ray absorbent, a dye or a pigment is preferably used.

As the dye, commercially available dyes and known dyes described in the literatures such as "Dye Handbook" (edited by The Society of Synthetic Organic Chemistry, Japan, published in 1970) can be used. Specific examples thereof include dyes such as an azo dye, a metal complex salt azo dye, a pyrazolone azo dye, a naphthoquinone dye, an anthraquinone dye, a phthalocyanine dye, a carbonium dye, a quinone imine dye, a methine dye, a cyanine dye, a squarylium coloring agent, a pyrylium salt, and a metal thiolate complex.

Among the above-described dyes, a cyanine coloring agent, a squarylium coloring agent, a pyrylium salt, a nickel thiolate complex, and an indolenine cyanine coloring agent are particularly preferable. Further, a cyanine coloring agent or an indolenine cyanine coloring agent is preferable and a cyanine coloring agent represented by Formula (a) is exemplified as a particularly preferred example.

Formula (a)

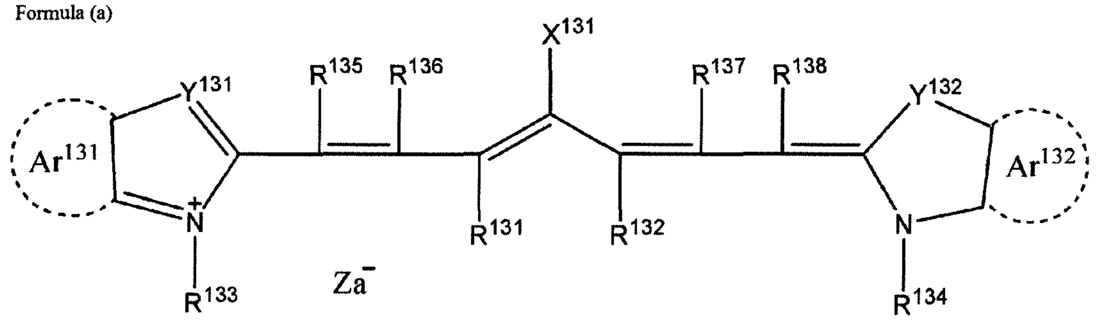

In Formula (a), $X^{131}$ represents a hydrogen atom, a halogen atom, $-NPh_2$, $-X^{132}-L^{131}$, or a group represented by the following formula. Further, Ph represents a phenyl group.

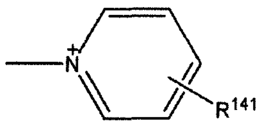

Xa$^-$

Here, $X^{132}$ represents an oxygen atom, a nitrogen atom, or a sulfur atom, $L^{131}$ represents a hydrocarbon group having 1 to 12 carbon atoms, an aryl group having heteroatoms (for example, N, S, O, a halogen atom, and Se), or a hydrocarbon group which has heteroatoms and 1 to 12 carbon atoms. $X_a^-$ has the same definition as that for $Za^-$ described below. $R^{141}$ represents a substituent selected from a hydrogen atom, an alkyl group, an aryl group, a substituted or unsubstituted amino group, and a halogen atom.

$R^{131}$ and $R^{132}$ each independently represent a hydrocarbon group having 1 to 12 carbon atoms. From the viewpoint of preservation stability of an image recording layer coating solution, it is preferable that $R^{131}$ and $R^{132}$ represent a hydrocarbon group having two or more carbon atoms. $R^{131}$ and $R^{132}$ may be linked to each other to form a ring. Further, during formation of a ring, it is particularly preferable to form a 5- or 6-membered ring.

$Ar^{131}$ and $Ar^{132}$ may be the same as or different from each other and each represent an aryl group which may have a substituent. Preferred examples of the aryl group include a benzene ring group and a naphthalene ring group. In addition, preferred examples of a substituent include a hydrocarbon group having 12 or less carbon atoms, a halogen atom, and an alkoxy group having 12 or less carbon atoms. $Y^{131}$ and $Y^{132}$ may be the same as or different from each other and each represent a sulfur atom or a dialkylmethylene group having 12 or less carbon atoms. $R^{133}$ and $R^{134}$ may be the same as or different from each other and each represent a hydrocarbon group having 20 or less carbon atoms which may have a substituent. Preferred examples of the substituent include an alkoxy group having 12 or less carbon atoms, a carboxyl group, and a sulfo group. $R^{135}$, $R^{136}$, $R^{137}$, and $R^{138}$ may be the same as or different from each other and each represent a hydrogen atom or a hydrocarbon group having 12 or less carbon atoms. From the viewpoint of availability of a raw material, it is preferable that $R^{135}$, $R^{136}$, $R^{137}$, and $R^{138}$ represent a hydrogen atom. In addition, $Za^-$ represents a counter anion. Here, the cyanine coloring agent represented by Formula (a) has an anionic substituent in the structure thereof, and $Z_a^-$ is not necessary in a case where neutralization of the charge is not necessary. From the viewpoint of preservation stability of the image recording layer coating solution, it is preferable that $Za^-$ represents a halide ion, a perchlorate ion, a tetrafluoroborate ion, a hexafluorophosphate ion, or a sulfonate ion and particularly preferable that $Za^-$ represents a perchlorate ion, a hexafluorophosphate ion, or an arylsulfonate ion.

Specific examples of the cyanine coloring agent represented by Formula (a) include compounds described in paragraphs [0017] to [0019] of JP2001-133969A and compounds described in paragraphs [0016] to [0021] of JP2002-023360A and paragraphs [0012] to [0037] of JP2002-040638A. Preferred examples thereof include compounds described in paragraphs [0034] to [0041] of JP2002-278057A and paragraphs [0080] to [0086] of JP2008-195018A and particularly preferred examples thereof include compounds described in paragraphs [0035] to [0043] of JP2007-90850A.

Further, compounds described in paragraphs [0008] and [0009] of JP1993-5005A (JP-H05-5005A) and compounds described in paragraphs [0022] to [0025] of JP2001-222101A can be preferably used.

Further, the above-described infrared-ray absorbent dyes may be used alone or in combination of two or more kinds thereof, and infrared-ray absorbents other than the infrared-ray absorbent dyes such as pigments may be used in combination. As the pigments, compounds described in paragraphs [0072] to [0076] of JP2008-195018A are preferable.

The content of the infrared-ray absorbent is preferably in a range of 0.05 to 30 parts by mass, more preferably in a range of 0.1 to 20 parts by mass, and particularly preferably in a range of 0.2 to 10 parts by mass with respect to 100 parts by mass of the total solid content of the image recording layer.

(Other binder polymers)

The image recording layer may further contain other binder polymers in addition to the above-described specific polymer. As other binder polymers, binder polymers in image recording layers of known planographic printing plate precursors of the related art can be selected and used. Among these, linear organic polymers having coated-film properties are preferable. Examples of such binder polymers include an acrylic resin, a polyvinyl acetal resin, a polyurethane resin, a polyurea resin, an epoxy resin, a methacrylic resin, a polystyrene resin, a novolac type phenolic resin, a polyester resin, synthetic rubber, and natural rubber.

The binder polymer may have cross-linking properties in order to improve coated-film hardness of an image area. In order to allow the binder polymer to have cross-linking properties, a cross-linkable functional group such as an ethylenic unsaturated bond may be introduced to the main chain or the side chain of a polymer. The cross-linkable functional group may be introduced by copolymerization.

Examples of the polymer having an ethylenic unsaturated bond in the main chain of a molecule include poly-1,4-butadiene and poly-1,4-isoprene.

As an example of the polymer having an ethylenic unsaturated bond in the side chain of a molecule, a polymer of an ester or an amide of acrylic acid or methacrylic acid, in which a residue (R of -COOR or CONHR) of the ester or the amide has an ethylenic unsaturated bond may be exemplified.

Examples of the residue (the above-described R) having an ethylenic unsaturated bond include $-CR^1=CR^2R^3$, $-(CH_2)_nCR^1=CR^2R^3$, $-(CH_2O)_nCH_2CR^1=CR^2R,^3$ $-(CH_2CH_2O)_nCH_2CR^1CR^2R^3$, $-(CH_2)_nNH-CO-O-CH_2CR^1=CR^2R^3$, $-(CH2)_n-O-CO-CR^1=CR^2R^3$, and $(CH_2CH_2O)_2-X$ (in the formula, $R^1$ to $R^3$ each independently represent a hydrogen atom, a halogen atom, or an alkyl group, an aryl group, an alkoxy group, or an aryloxy group having 1 to 20 carbon atoms, $R^1$ and $R^2$ or $R^3$ may be bonded to each other to form a ring, n represents an integer of 1 to 10, and X represents a dicyclopentadienyl residue).

Specific examples of the ester residue (the above-described R) include $-CH=CH_2$, $-C(CH_3)=CH_2$, $-CH_2CH=CH_2$ (described in JP1995-21633B (JP-H07-21633B)), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$, and $CH_2CH_2O-X$ (in the formula, X represents a dicyclopentadienyl residue).

Specific examples of the amide residue (the above-described R) include $-CH=CH_2$, $-C(CH_3)=CH_2$, $-CH_2CH=CH_2$, $-CH_2CH_2-Y$ (in the formula, Y represents a cyclohexene residue), and $-CH_2CH_2-OCO-CH=CH_2$.

In the binder compound having cross-linking properties, for example, a free radical (growth radical in the step of polymerization of a polymerization initiating radical or a polymerizable monomer) is added to the cross-linkable functional group thereof so that addition polymerization is carried out directly between polymers or through a polymerization chain of a polymerizable monomer, and cross-linking occurs between polymer molecules so that curing is promoted. Alternatively, atoms (hydrogen atom on carbon atoms adjacent to the functional cross-linking group) in the polymers are pulled out by free radicals so that polymer radicals are generated, and cross-linking occurs between polymer molecules so that curing is promoted by the polymer radicals being bonded to each other.

From the viewpoints excellent sensitivity and excellent storage stability, the content (content of radically polymerizable unsaturated double bond by iodine titration) of the cross-linkable group in the binder polymer is preferably in a range of 0.1 to 10.0 mmol, more preferably in a range of 1.0 to 7.0 mmol, and particularly preferably in a range of 2.0 to 5.5 mmol per 1 g of the binder polymer.

From the viewpoint of improving on-press developability, it is preferable that the solubility or dispersibility of the binder polymer in ink and/or dampening water is high.

In order to improve the solubility or dispersibility of the binder polymer in ink, it is preferable that the binder polymer is lipophilic. Further, in order to improve the solubility or dispersibility of the binder polymer in dampening water, it is preferable that the binder polymer is hydrophilic. Therefore, in the present invention, it is also effective that a lipophilic binder polymer and a hydrophilic binder polymer are used in combination.

Preferred examples of the hydrophilic binder polymer include those having hydrophilic groups such as a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amide group, a carboxymethyl group, a sulfo group, and a phosphoric acid group.

Specific examples of the hydrophilic binder polymer include gum arabic, casein, gelatin, a starch derivative, carboxy methyl cellulose and sodium salts thereof, cellulose acetate, sodium alginate, vinyl acetate-maleic acid copolymers, styrene-maleic acid copolymers, polyacrylic acids and salts of these, polymethacrylic acids and salts of these, a homopolymer and a copolymer of hydroxy ethyl methacrylate, a homopolymer and a copolymer of hydroxy ethyl acrylate, a homopolymer and a copolymer of hydroxy propyl methacrylate, a homopolymer and a copolymer of hydroxy propyl acrylate, a homopolymer and a copolymer of hydroxy butyl methacrylate, a homopolymer and a copolymer of hydroxy butyl acrylate, polyethylene glycols, hydroxy propylene polymers, polyvinyl alcohols, hydrolyzed polyvinyl acetate having a degree of hydrolysis of 60% by mole or greater and preferably 80% by mole or greater, polyvinyl formal, polyvinyl butyral, polyvinyl pyrrolidone, a homopolymer and a copolymer of acrylamide, a homopolymer and a copolymer of methacrylamide, a homopolymer and a copolymer of N-methylol acrylamide, polyvinylpyrrolidone, and polyether of 2,2-bis-(4-hydroxyphenyl)-propane and epichlorohydrin.

The mass average molecular weight (Mw) of the binder polymer is preferably 5000 or greater and more preferably in a range of 10000 to 300000; and the number average molecular weight of the binder polymer is preferably 1000 or greater and more preferably in a range of 2000 to 250000. The polydispersity (mass average molecular weight/number average molecular weight) of the binder polymer is preferably in a range of 1.1 to 10.

The binder polymer may be any of a random polymer or a block polymer, but a random polymer is preferable. The binder polymer may be used alone or in mixture of two or more kinds thereof.

As the binder polymer, commercially available products may be used or the binder polymer may be synthesized according to a conventionally known method. Examples of the solvent used for synthesizing the binder polymer include tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethylformamide, N,N-dimethylacetamide, toluene, ethyl acetate, methyl lactate, ethyl lactate, dimethyl sulfoxide, and water. The solvent may be used alone or in mixture of two or more kinds thereof.

As the radical polymerization initiator used for synthesizing the binder polymer, known compounds such as an azo-based initiator and a peroxide initiator can be used.

In the present invention, in a case where the above-described specific polymer is used together with other binder polymers, from the viewpoints of excellent strength of the image area and excellent image formability, the content of other binder polymers is typically 80% by mass or less, preferably 50% by mass or less, and more preferably 30% by mass or less with respect to the total solid content of the image recording layer.

(Low-molecular-weight hydrophilic compound)

In order to improve the on-press developability without degrading the printing durability, the image recording layer may contain a low-molecular-weight hydrophilic compound.

As the low-molecular-weight hydrophilic compound, examples of a water-soluble organic compound include glycols such as ethylene glycol, diethylene glycol, triethylene glycol, propylene glycol, dipropylene glycol, and tripropylene glycol and ether or ester derivatives thereof; polyols such as glycerin, pentaerythritol, and tris(2-hydroxyethyl) isocyanurate; organic amines such as triethanolamine, diethanolamine, and monoethanolamine and salts thereof; organic sulfonic acids such as alkylsulfonic acid, toluenesulfonic acid, and benzenesulfonic acid and salts thereof; organic sulfamic acids such as alkyl sulfamic acid and salts thereof; organic sulfuric acids such as alkyl sulfuric acid and alkyl ether sulfuric acid and salts thereof; organic phosphonic acids such as phenyl phosphonic acid and salts thereof; organic carboxylic acids such as tartaric acid, oxalic acid, citric acid, malic acid, lactic acid, gluconic acid, and amino acids and salts thereof; and betaines.

Among examples of the low-molecular-weight hydrophilic compound, it is preferable that the image recording layer contains at least one selected from the group consisting of polyols, organic sulfates, organic sulfonates, and betaines.

Specific examples of the compound of an organic sulfonate include an alkyl sulfonate such as sodium n-butyl sulfonate, sodium n-hexyl sulfonate, sodium 2-ethylhexyl sulfonate, sodium cyclohexyl sulfonate, or sodium n-octyl sulfonate; an alkyl sulfonate containing an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, or sodium 5,8,11,14-tetraoxatetradecosane-1-sulfonate; an aryl sulfonate such as sodium benzene sulfonate, sodium p-toluene sulfonate, sodium p-hydroxybenzene sulfonate, sodium p-styrene sulfonate, sodium isophthalic acid dimethyl-5-sulfonate, sodium 1-naphthyl sulfonate, sodium 4-hydroxynaphthyl sulfonate, disodium 1,5-naphthalene disulfonate, trisodium 1,3,6-naphthalene trisulfonate; and compounds described in paragraphs [0026] to [0031] of JP2007-276454A and paragraphs [0020] to [0047] of JP2009-154525A. The salt may be a potassium salt or a lithium salt.

Examples of the organic sulfate include an alkyl, an alkenyl, an alkynyl, an aryl of polyethylene oxide and a sulfate of heterocyclic monoether. The number of ethylene oxide units is preferably in a range of 1 to 4. As a salt, a sodium salt, a potassium salt, or a lithium salt is preferable. Specific examples of these include compounds described in paragraphs [0034] to [0038] of JP2007-276454.

As betaines, compounds having 1 to 5 carbon atoms of hydrocarbon substituents to nitrogen atoms are preferable. Specific examples thereof include trimethyl ammonium acetate, dimethyl propyl ammonium acetate, 3-hydroxy-4-trimethyl ammonio butyrate, 4-(1-pyridinio)butyrate, 1-hydroxyethyl-1-imidazolioacetate, trimethyl ammonium methane sulfonate, dimethyl propyl ammonium methane sulfonate, 3-trimethylammonio-1-propane sulfonate, and 3-(1-pyridinio)-1-propane sulfonate.

Since the low-molecular-weight hydrophilic compound has a small structure of a hydrophobic portion, hydrophobicity or coated-film hardness of an image area is not degraded by dampening water permeating into an exposed portion (image area) of the image recording layer and ink receptivity or printing durability of the image recording layer can be maintained satisfactorily.

From the viewpoints of excellent on-press developability and printing durability, the content of the low-molecular-weight hydrophilic compounds is preferably in a range of 0.5% to 20% by mass, more preferably in a range of 1% to 15% by mass, and still more preferably in a range of 2% to 10% by mass with respect to the total solid content of the image recording layer. The low-molecular-weight hydrophilic compounds may be used alone or in mixture of two or more kinds thereof.

(Sensitizing agent)

In order to improve the ink receptivity, it is preferable that the image recording layer contains a sensitizing agent such as a phosphonium compound, a nitrogen-containing low-molecular-weight compound, or an ammonium group-containing polymer. Particularly, in a case where a protective layer contains an inorganic layered compound, the sensitizing agent functions as a surface coating agent of the inorganic layered compound and prevents a degradation in ink receptivity due to the inorganic layered compound during the printing.

Examples of the phosphonium compound include phosphonium compounds described in JP2006-297907A and JP2007-50660A. Specific examples thereof include tetrabutyl phosphonium iodide, butyl triphenyl phosphonium bromide, tetraphenyl phosphonium bromide, 1,4-bis(triphenylphosphonio)butane=di(hexafluorophosphate), 1,7-bis(triphenylphosphonio)heptane=sulfate, and 1,9-bis(triphenylphosphonio)nonane=naphthalene-2,7-disulfonate.

Examples of the nitrogen-containing low-molecular-weight compound include amine salts, and quaternary ammonium salts. Further, examples thereof include imidazolinium salts, benzimidazolinium salts, pyridinium salts, and quinolinium salts. Among these, quaternary ammonium salts and pyridinium salts are preferable. Specific examples thereof include tetramethyl ammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, and compounds described in paragraphs [0021] to [0037] of JP2008-284858A and paragraphs [0030] to [0057] of JP2009-90645A.

The ammonium group-containing polymer is not particularly limited as long as the polymer contains an ammonium group in the structure thereof, but a polymer that contains, as a copolymerization component, 5% to 80% by mole of (meth)acrylate having an ammonium group in the side chain is preferable. Specific examples thereof include polymers described in paragraphs [0089] to [0105] of JP2009-208458A.

The reduced specific viscosity (unit: ml/g) of the ammonium salt-containing polymer which is acquired by the following measurement method is preferably in a range of 5 to 120, more preferably in a range of 10 to 110, and particularly preferably in a range of 15 to 100. In a case where the reduced specific viscosity is converted into the mass average molecular weight, the value thereof is preferably in a range of 10000 to 150000, more preferably in a range of 17000 to 140000, and particularly preferably in a range of 20000 to 130000.

«Method of measuring reduced specific viscosity»

3.33 g (1 g as a solid content) of a 30% polymer solution is weighed using a 20 ml of measuring flask and is diluted with N-methylpyrrolidone. This solution is allowed to stand in a constant-temperature tank at 30°C for 30 minutes and put into an Ubbelohde reduced viscosity tube (viscometer constant: 0.010 cSt/s), and then the time for the solution to fall down at 30°C is measured. Further, the measurement is performed two times using the same sample and the average value thereof is calculated. Similarly, also in a case of the blank (only N-methylpyrrolidone), the measurement is performed and the reduced specific viscosity (ml/g) is calculated from the following equation.

$$\text{Reduced specific viscosity}\ (ml/g) = \frac{\dfrac{\text{Time for sample solution to fall down (sec)} - \text{time for blank to fall down (sec)}}{\text{Time for blank to fall down (sec)}}}{\dfrac{3.33\,(g) \times \dfrac{30}{100}}{20\,(ml)}}$$

Hereinafter, specific examples of the ammonium group-containing polymer will be described.

(1) A 2-(trimethylammonio)ethylmethacrylate=p-toluenesulfonate/3,6-dioxaheptylmethacrylate copolymer (molar ratio of 10/90, mass average molecular weight of 45000);
(2) A 2-(trimethylammonio)ethylmethacrylate=hexafluorophosphate/3,6-dioxaheptylmethacrylate copolymer (molar ratio of 20/80, mass average molecular weight of 60000),
(3) A 2-(ethyldimethylammonio)ethylmethacrylate=p-toluenesulfonate/hexylmethacrylate copolymer (molar ratio of 30/70, mass average molecular weight of 45000);
(4) A 2-(trimethylammonio)ethylmethacrylate=hexafluorophosphate/2-ethylhexylmethacrylate copolymer (molar ratio of 20/80, mass average molecular weight of 60000);
(5) A 2-(trimethylammonio)ethylmethacrylate=methylsulfate/hexylmethacrylate copolymer (molar ratio of 40/60, mass average molecular weight of 70000);
(6) A 2-(butyldimethylammonio)ethylmethacrylate=hexafluorophosphate/3,6-dioxaheptylmethacryla te copolymer (molar ratio of 25/75, mass average molecular weight of 65000);
(7) A 2-(butyldimethylammonio)ethylacrylate=hexafluorophosphate/3,6-dioxaheptylmethacrylate copolymer (molar

ratio of 20/80, mass average molecular weight of 65000);

(8) A 2-(butyldimethylammonio)ethylmethacrylate=13-ethyl-5,8,11-trioxa-1-heptadecanesulfonate/3 ,6-dioxaheptylmethacrylate copolymer (molar ratio of 20/80, mass average molecular weight of 75000); and

(9) A 2-(butyldimethylammonio)ethylmethacrylate=hexafluorophosphate/3,6-dioxaheptylmethacryla te/2-hydroxy-3-methacryloxypropylmethacrylate copolymer (molar ratio of 15/80:5, mass average molecular weight of 65000)

The content of the sensitizing agent is preferably in a range of 0.01% to 30.0% by mass, more preferably in a range of 0.1% to 15.0% by mass, and still more preferably in a range of 1% to 5% by mass with respect to the total solid content of the image recording layer.

(Hydrophobic precursor)

In order to improve the on-press developability, the image recording layer may contain a hydrophobic precursor. The hydrophobic precursor indicates a fine particle which is capable of making the image recording layer hydrophobic in a case of being heated. It is preferable that the fine particle is at least one selected from a hydrophobic thermoplastic polymer fine particle, a thermally reactive polymer fine particle, a polymer fine particle containing a polymerizable group, a microcapsule including a hydrophobic compound, and a microgel (cross-linked polymer fine particle). Among these, a polymer fine particle containing a polymerizable group and a microgel are preferable.

Preferred examples of the hydrophobic thermoplastic polymer fine particles include hydrophobic thermoplastic polymer fine particles described in Research Disclosure No. 33003 on January, 1992, and the specifications of JP1997-123387A (JP-H09-123387A), JP1997-131850A (JP-H09-131850A), JP1997-171249A (JP-H09-171249A), JP1997-171250A (JP-H09-171250A), and EP931647B.

Specific examples of a polymer constituting hydrophobic thermoplastic polymer fine particles include homopolymers or copolymers of monomers such as acrylate or methacrylate having structures of ethylene, styrene, vinyl chloride, methyl acrylate, ethyl acrylate, methyl methacrylate, ethyl methacrylate, vinylidene chloride, acrylonitrile, vinyl carbazole, and polyalkylene, and mixtures of these. Among these, polystyrene, styrene, a copolymer containing acrylonitrile, and polymethylmethacrylate are more preferable.

The average particle diameter of the hydrophobic thermoplastic polymer fine particles is preferably in a range of 0.01 to 2.0 μm.

Examples of the thermally reactive polymer fine particles include polymer fine particles having a thermally reactive group. The thermally reactive polymer fine particles are cross-linked by a thermal reaction and have hydrophobic regions formed by a change in functional groups during the cross-linking.

As the thermally reactive group in polymer fine particles having a thermally reactive group, a functional group that performs any reaction may be used as long as a chemical bond is formed, but a polymerizable group is preferable. Preferred examples of the polymerizable group include an ethylenic unsaturated group that performs a radical polymerization reaction (such as an acryloyl group, a methacryloyl group, a vinyl group, or an allyl group); a cationic polymerizable group (such as a vinyl group, a vinyloxy group, an epoxy group, or an oxetanyl group); an isocyanate group that performs an addition reaction or a block body thereof, an epoxy group, a vinyloxy group, and a functional group having active hydrogen atoms as the reaction partners of these (such as an amino group, a hydroxy group, or a carboxy group); a carboxy group that performs a condensation reaction and a hydroxy group or an amino group as a reaction partner thereof; and an acid anhydride that performs a ring opening addition reaction and an amino group or a hydroxy group as a reaction partner thereof.

The microcapsule is a microcapsule which includes a part or the entire constituent component of the image recording layer as described in JP2001-277740A and JP2001-277742A. Further, the constituent component of the image recording layer may also be contained in a portion other than the microcapsule. Moreover, a preferred aspect of the image recording layer containing the microcapsule is an embodiment in which hydrophobic constituent components are included in a microcapsule and hydrophilic constituent components are contained in a portion other than the microcapsule.

The microgel may contain a part of the constituent components of the image recording layer in at least one of the surface or the inside thereof. From the viewpoints of image forming sensitivity and printing durability, a reactive microgel having a radical polymerizable group on the surface thereof is particularly preferable.

The constituent components of the image recording layer can be made into microcapsules or microgel particles using a known method.

From the viewpoints of the excellent resolution and temporal stability, the average particle diameter of the microcapsules or microgels is preferably in a range of 0.01 to 3.0 μm, more preferably in a range of 0.05 to 2.0 μm, and still more preferably in a range of 0.10 to 1.0 μm.

The content of the hydrophobic precursor is preferably in a range of 5% to 90% by mass with respect to the total solid content of the image recording layer.

(Reducing agent)

From the viewpoint of improving the printing durability, the image recording layer may contains a reducing agent. The following five kinds are preferably exemplified as the examples of the reducing agent.

(i) Alkyl or arylate complex: It is considered that a carbon-hetero bond is oxidatively dissociated and an active radical is generated. Specifically, a borate salt compound is preferably used.
As the borate salt compound, organic borates described in JP1987-143044A (JP-S62-143044A), JP1987-150242A (JP-S62-150242A), JP1997-188685A (JP-H09-188685A), JP1997-188686A (JP-H09-188686A), JP1997-188710A (JP-H09-188710A), JP2000-131837A, JP2002-107916A, JP2764769B, JP2002-116539A, and "Rad Tech' 98. Proceeding April 19 to 22, 1998, Chicago" written by Kunz, Martin are preferable.
(ii) N-arylalkylamine compound: It is considered that a C-X bond on carbon adjacent to nitrogen is dissociated due to oxidation and an active radical is generated. As X, a hydrogen atom, a carboxyl group, a trimethylsilyl group, or a benzyl group is preferable. Specific examples thereof include N-phenylglycines (the phenyl group may or may not include a substituent) and N-phenyliminodiacetic acid (the phenyl group may or may not include a substituent) which are described in the following chemical formulae.

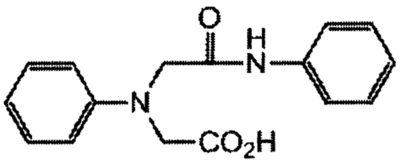
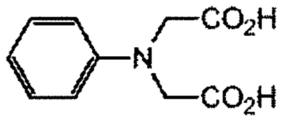
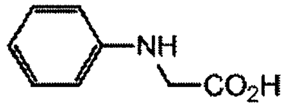

(iii) Sulfur-containing compound: An active radical can be generated from the above-described amines in which nitrogen atoms are substituted with sulfur atoms, through the same action. Examples thereof include phenylthioacetic acid (the phenyl group may or may not include a substituent).
(iv) Tin compound: An active radical can be generated from the above-described amines in which nitrogen atoms are substituted with tin atoms, through the same action.
(v) Sulfinates: An active radical can be generated through oxidation. Specific examples thereof include sodium arylsulfinate.

The reducing agent may be used alone or in combination of two or more kinds thereof.
The content of the reducing agent is preferably in a range of 0.01% to 30% by mass, more preferably in a range of 0.05% to 25% by mass, and still more preferably in a range of 0.1 % to 20% by mass with respect to the total solid content of the image recording layer.
Hereinafter, preferred examples of the reducing agent will be described, but the present invention is not limited to these. Further, in the exemplary compounds, Me represents a methyl group, Et represents an ethyl group, and n-Bu represents an n-butyl group.

(F-1)
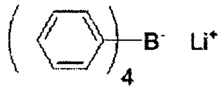
(F-2)
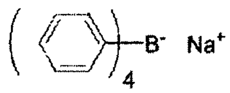
(F-3)
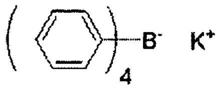
(F-4)
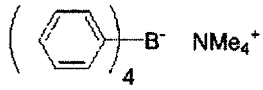

(F-5)
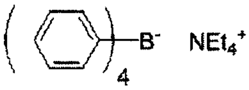
(F-6)
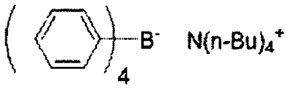
(F-7)
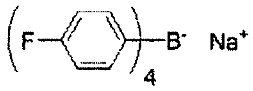
(F-8)
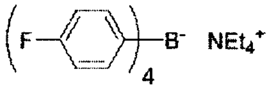

(F-9)
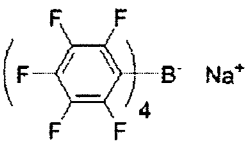
(F-10)
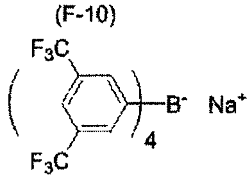
(F-11)
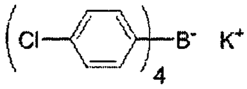
(F-12)
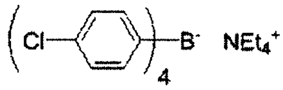

(F-13)
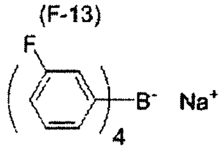
(F-14)
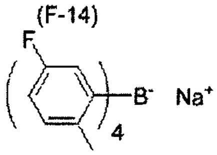
(F-15)
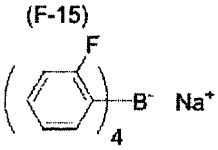
(F-16)
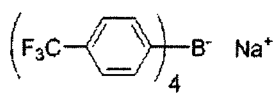

(F-17)
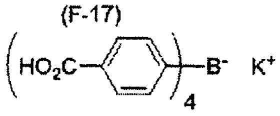
(F-18)
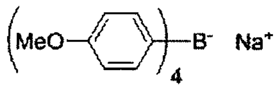
(F-19)
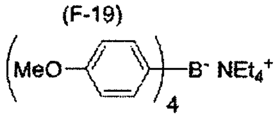
(F-20)
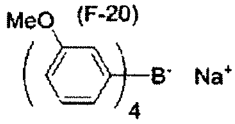

(F-21)
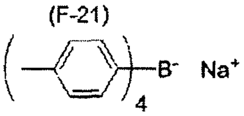
(F-22)
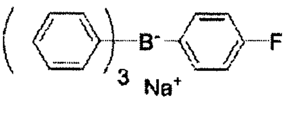
(F-23)
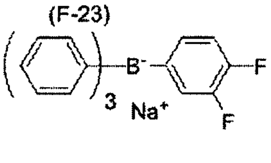
(F-24)
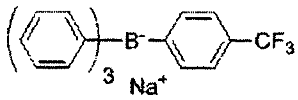

(F-25)
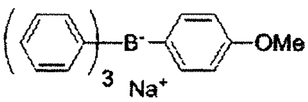
(F-26)
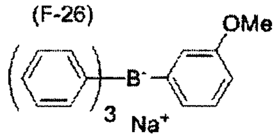
(F-27)
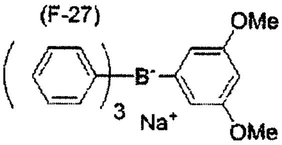

(F-28)
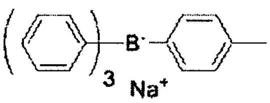
(F-29)
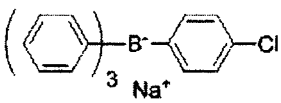

(Other image recording layer components)

The image recording layer may contain a chain transfer agent. The chain transfer agent is defined, for example, in Polymer Dictionary Third Edition (edited by The Society of Polymer Science, Japan, 2005), pp. 683 and 684. For example, a compound group having SH, PH, SiH, and GeH in a molecule is used as the chain transfer agent. With these, radicals are generated by donating hydrogen to low active radical species or radicals can be generated by deprotonation after oxidation. Further, particularly, thiol compounds (such as 2-mercaptobenzimidazoles, 2-mercaptobenzthiazoles, 2-mercaptobenzoxazoles, 3-mercaptotriazoles, and 5-mercaptotetrazoles) can be preferably used for the image recording layer.

The content of the chain transfer agent is preferably in a range of 0.01 to 20 parts by mass, more preferably in a range of 1 to 10 parts by mass, and particularly preferably in a range of 1 to 5 parts by mass with respect to 100 parts by mass of the total solid content of the image recording layer.

The image recording layer may further contain various additives as necessary. Examples of the additives include a surfactant for promoting developability and improving the coated surface state; a hydrophilic polymer for improving developability and improving dispersion stability of microcapsules; a colorant or a print-out agent for visually recognizing an image area and a non-image area; a polymerization inhibitor for preventing unnecessary thermal polymerization of a polymerizable compound during production or storage of the image recording layer; a hydrophobic low-molecular-weight compound such as a higher fatty derivative for preventing polymerization inhibition due to oxygen; inorganic fine particles and organic fine particles for improving cured film hardness of an image area; a co-sensitizer for improving sensitivity; and a plasticizer for improving plasticity. As these compounds, known compounds described in paragraphs [0161] to [0215] of JP2007-206217A, paragraph [0067] of JP2005-509192A, and paragraphs [0023] to [0026] and [0059] to [0066] of JP2004-310000A can be used.

(Formation of image recording layer)

The method of forming the image recording layer is not particularly limited, and a known method can be used

for formation. The image recording layer is formed by dispersing or dissolving necessary each of the image recording layer components in a solvent to prepare a coating solution and applying the solution. Examples of the solvent to be used include methyl ethyl ketone, ethylene glycol monomethyl ether, 1-methoxy-2-propanol, 2-methoxyethyl acetate, 1-methoxy-2-propyl acetate, and γ-butyl lactone, but the present invention is not limited to these. The solvent may be used alone or in combination. The concentration of solid contents in the coating solution is preferably in a range of 1% to 50% by mass.

The coating amount (solid content) of the image recording layer is preferably in a range of 0.3 to 3.0 g/$m^2$. Various methods can be used as the coating method. Examples thereof include bar coater coating, spin coating, spray coating, curtain coating, dip coating, air knife coating, blade coating, and roll coating.

[Support]

The support used in the planographic printing plate precursor of the present invention is not particularly limited as long as the support is a plate-like hydrophilic support which is dimensionally stable. An aluminum plate is particularly preferable as the support. It is preferable that a surface treatment such as a surface roughening treatment or anodizing treatment is performed before using an aluminum plate. The surface roughening treatment is performed on the surface of the aluminum plate according to various methods, and examples thereof include a mechanical surface roughening treatment, an electrochemical surface roughening treatment (a surface roughening treatment of electrochemically dissolving the surface), and a chemical surface roughening treatment (a surface roughening treatment of selectively and chemically dissolving the surface). Methods described in paragraphs [0241] to [0245] of JP2007-206217A can be preferably used for these treatments.

Examples of the anodizing treatment to be performed on the surface of an aluminum plate include sulfuric acid anodization and phosphoric acid anodization. The anodic pore size in a case of the phosphoric acid anodization is typically greater than 30 nm while the anodic pore side in a case of the sulfuric acid anodization is typically less than 20 nm.

Further, other conventional anodization methods such as a method of forming an anodic pore size greater than the anodic pore side formed by the sulfuric acid anodization can be also used. Further, a method of anodizing an aluminum plate using a combination of acids, for example, a mixture of acids (for example, a mixture of phosphoric acid and sulfuric acid) or a method of performing sequential anodization (for example, phosphoric acid anodization followed by sulfuric acid anodization or vice versa) using two or more kinds of acids is also preferable.

From the viewpoints of excellent adhesiveness between the support and the undercoat layer or the image recording layer to be formed on the support, excellent printing durability, and excellent antifouling properties, the center line average roughness of the support is preferably in a range of 0.10 to 1.2 μm.

Further, from the viewpoints of excellent image formability resulting from prevention of halation at the time of image exposure and excellent plate inspectability after development, the color density of the support is preferably in a range of 0.15 to 0.65 in terms of reflection density value.

The thickness of the support is preferably in a range of 0.1 to 0.6 mm, more preferably in a range of 0.15 to 0.4 mm, and still more preferably in a range of 0.2 to 0.3 mm.

In the planographic printing plate precursor of the present invention, it is preferable that a hydrophilic treatment is further performed on the surface of the support which has been subjected to the above-described surface treatment in order to improve the hydrophilicity of the non-image area region and prevent printing stain.

Examples of the method for the hydrophilic treatment to be performed on the surface of the support include an alkali metal silicate treatment of performing an immersion treatment or an electrolytic treatment on the support in an aqueous solution such as sodium silicate; a method of treating the surface with potassium fluorozirconate, and a method of treating the surface with polyvinylphosphoric acid. In addition, a method of performing an immersion treatment on the surface in a polyvinylphosphonic acid aqueous solution is preferably used.

[Undercoat layer]

The planographic printing plate precursor of the present invention may include an undercoat layer between the support and the image recording layer. Preferred exemples of the compound contained in the undercoat layer include a silane coupling agent having an ethylenic double bond reaction group, which can be added and polymerized, described in JP1998-282679A (JP-H10-282679A); and a phosphorous compound having an ethylenic double bond reaction group described in JP1990-304441A (JP-H02-304441A). Particularly preferred examples thereof include compounds containing a polymerizable group such as a methacryl group or an allyl group; and a support adsorptive group such as a sulfonic acid group, a phosphoric acid group, or phosphoric acid ester. In addition to these polymerizable groups and support adsorptive groups, compounds containing a hydrophilicity imparting group such as an ethylene oxide group can be exemplified as the suitable compound.

The undercoat layer can be provided according to a method of coating the support with a solution obtained by

dissolving the above-described compound in water, an organic solvent such as methanol, ethanol, or methyl ethyl ketone, or a mixed solvent of these and drying the support; or a method of immersing the support in a solution obtained by dissolving the above-described compound in water, an organic solvent such as methanol, ethanol, or methyl ethyl ketone, or a mixed solvent of these to adsorb the compound, washing the support with water, and drying the support. According to the former method, the support can be coated with a solution containing the compound at a concentration of 0.005% to 10% by mass using various methods.

For example, any method of bar coater coating, spin coating, spray coating, and curtain coating may be used for application of the undercoat layer coating solution. According to the latter method, the concentration of the solution is in a range of 0.01% to 20% by mass and preferably in a range of 0.05% to 5% by mass; the immersion temperature is in a range of 20°C to 90°C and preferably in a range of 25°C to 50°C, and the immersion time is in a range of 0.1 seconds to 20 minutes and preferably in a range of 2 seconds to 1 minute.

The coating amount (solid content) of the undercoat layer is preferably in a range of 0.1 to 100 mg/$m^2$ and more preferably in a range of 1 to 30 mg/$m^2$.

[Protective layer]

In the planographic printing plate precursor of the present invention, it is preferable that a protective layer is provided on the image recording layer in order to block diffusion penetration of oxygen that disturbs a polymerization reaction during exposure. As the material of the protective layer, any of a water-soluble polymer and a water-insoluble polymer can be appropriately selected and used, and two or more kinds thereof can be used in combination as necessary. Specific examples thereof include polyvinyl alcohol, modified polyvinyl alcohol, polyvinylpyrrolidone, a water-soluble cellulose derivative, and poly(meth)acrylonitrile. Among these, a water-soluble polymer compound having relatively excellent crystallinity is preferably used. Specifically, in a case where polyvinyl alcohol is used as a main component, this leads to excellent results particularly for basic characteristics of the protective layer such as oxygen blocking properties and development removability.

Since polyvinyl alcohol used for the protective layer has necessary oxygen blocking properties and water solubility, a part of the polyvinyl alcohol may be substituted with an ester, an ether, or an acetal as long as the polyvinyl alcohol contains a necessary unsubstituted vinyl alcohol unit. Further, similarly, a part thereof may contain other copolymerization components. The polyvinyl alcohol can be obtained by hydrolyzing polyvinyl acetate. Specific examples of the polyvinyl alcohol include those in which the degree of hydrolysis is in a range of 69.0% to 100% by mole and the number of polymerization repeating units is in a range of 300 to 2400. Specific examples thereof include PVA-102 PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706, and L-8 (all manufactured by KURARAY CO., LTD.). The polyvinyl alcohol can be used alone or in combination of two or more kinds thereof. The content of the polyvinyl alcohol in the protective layer is preferably in a range of 20% to 95% by mass and more preferably in a range of 30% to 90% by mass.

Further, the modified polyvinyl alcohol can also be preferably used. Particularly, acid-modified polyvinyl alcohol containing a carboxylic acid group or a sulfonic acid group is preferably used. Specifically, polyvinyl alcohol described in JP2005-250216A and JP2006-259137A is suitably exemplified.

In a case where polyvinyl alcohol is mixed with other materials and used, from the viewpoints of oxygen blocking properties and development removability, modified polyvinyl alcohol, polyvinylpyrrolidone, or a modified product thereof is preferable as the material to be mixed. The content thereof in the protective layer is preferably in a range of 3.5% to 80% by mass, more preferably in a range of 10% to 60% by mass, and still more preferably in a range of 15% to 30% by mass.

The flexibility can be imparted to the protective layer by adding several mass percent of glycerin, dipropylene glycol, or the like to the above-described protective layer-forming material. Further, several mass percent of an anionic surfactant such as sodium alkyl sulfate or sodium alkyl sulfonate; an amphoteric surfactant such as alkylaminocarboxylate or alkylaminodicarboxylate; or a non-ionic surfactant such as polyoxyethylene alkyl phenyl ether can be added to the above-described protective layer-forming material.

For the purpose of improving oxygen blocking properties or surface protection properties of the image recording layer, it is also preferable that the protective layer contains an inorganic layered compound. Among examples of the inorganic layered compound, a fluorine-based swellable synthetic mica which is a synthetic inorganic layered compound is particularly preferable. Specifically, inorganic layered compounds described in JP2005-119273A are suitably exemplified.

The coating amount of the protective layer is preferably in a range of 0.05 to 10 g/$m^2$, more preferably in a range of 0.1 to 5 g/$m^2$ in a case where the protective layer contains an inorganic layered compound, and still more preferably in a range of 0.5 to 5 g/$m^2$ in a case where the protective layer does not contain an inorganic layered compound.

[Back coat layer]

The planographic printing plate precursor of the present invention may include a back coat layer on the rear surface of the aluminum support as necessary. As the back coat layer, a coating layer formed of a metal oxide obtained by hydrolyzing and polycondensing an organic polymer compound described in JP1993-45885A (JP-H05-45885A) and an organic metal compound or an inorganic metal compound described in JP1994-35174A (JP-H06-35174A) is suitably exemplified. Among these, from the viewpoints of inexpensive raw materials and easily obtaining the raw materials, an alkoxy compound of silicon such as $Si(OCH_3)_4$, $Si(OC_2H_5)_4$, $Si(OC_3H_7)_4$, or $Si(OC_4H_9)_4$ is preferable.

[Plate-making method]

A plate-making method of the present invention includes a step of image-exposing the planographic printing plate precursor; and an on-press development step of performing development using oily ink and an aqueous component on a printing press.

<Exposing step>

The planographic printing plate precursor of the present invention can be image-exposed according to a method of scanning and exposing digital data using an infrared laser.

The wavelength of a light source is preferably in a range of 750 to 1400 nm. As the light source having a wavelength of 750 to 1400 nm, a solid-state laser or a semiconductor laser that radiates infrared rays is suitable. The exposure mechanism may be any of an internal drum system, an external drum system, and a flat bed system.

The exposing step can be performed using a plate setter according to a conventional method. The planographic printing plate precursor may be exposed on a printing press after being mounted on the printing press using a printing press provided with an exposure device.

<On-press development step>

In the on-press development step, an unexposed portion of the planographic printing plate precursor is removed at an initial stage of the printing, the surface of the hydrophilic support is exposed along with the removal, and a non-image area is formed in a case where oily ink and an aqueous component are supplied and the printing is initiated as it is without performing any development treatment on the image-exposed planographic printing plate precursor. As the oily ink and the aqueous component, typical printing ink for planographic printing and dampening water are used. Here, printing ink or dampening water may be initially supplied to the plate surface, but it is preferable that printing ink is initially supplied to the plate surface from a viewpoint of preventing contamination of dampening water by the removed image recording layer components.

In this manner, the planographic printing plate precursor is subjected to on-press development on an off-set printing press and used as it is for a plurality of sheets of printing.

Examples

Hereinafter, the features of the present invention will be described in detail with reference to examples, but the present invention is not limited to these. In the polymer compound, the molecular weight is a mass average molar mass (Mw) in terms of polystyrene according to a gel permeation chromatography (GPC) method and the ratio of repeating units is a molar fraction unless otherwise specified. The acid value is a value calculated by neutralization titration.

Hereinafter, synthesis examples of specific polymers and comparative polymers will be described.

(Synthesis Example 1: synthesis of specific polymer A-1)

A specific polymer A-1 was synthesized according to the following reaction scheme.

3.10 g (15.27 mmol) of isophthaloyl dichloride as bifunctional acid chloride, 320 mg (3.05 mmol) of methacryloyl chloride as monofunctional acid chloride, 25 mg of 2,2,6,6-tetramethylpiperidine-1-oxyl (TEMPO), and 37.5 g of N,N-dimethylacetamide (DMAc) were added to a 200 mL three-neck flask, and the solution was stirred at room temperature. A mixed solution of 6.57 g (15.27 mmol) of JEFFAMINE D-400 (manufactured by Huntsman Corporation), 3.40 g (33.6 mmol) of trimethylamine, and 19.44 g of DMAc, as an acid chloride reactive bifunctional compound, was prepared in a dropping funnel, and the mixed solution was added dropwise to the three-neck flask such that the temperature of the reaction solution was set to 30°C or lower. The solution was stirred at room temperature for 1 hour, 1.0 g of methanol was added to the solution, and then the solution was further stirred for 1 hour. As the result of dropwise addition of the

obtained reaction solution to 1000 g of distilled water, precipitation occurred. The obtained precipitation was recovered by removing the supernatant and washed with distilled water, and the obtained solid was dissolved in 40 g of 1-methoxy-2-propanol. After the remaining moisture was distilled off under reduced pressure, the amount of 1-methoxy-2-propanol was adjusted such that the solid content was set to 20%. A solution of a specific polymer A-1 in 1-methoxy-2-propanol was obtained by performing the above-described operation.

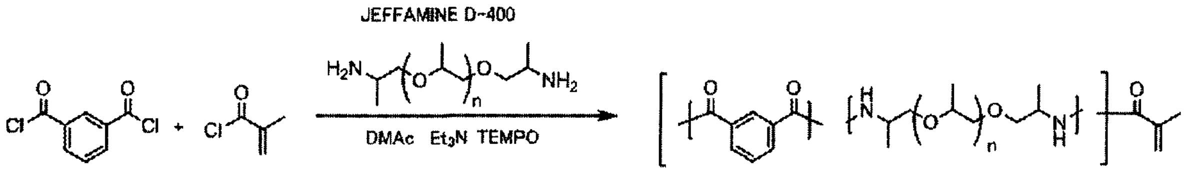


(Synthesis Examples 2 to 13: synthesis of specific polymers A-2 to A-13)

Solutions of specific polymers A-2 to A-13 in 1-methoxy-2-propanol were obtained in the same manner as in Synthesis Example 1 except that the types of the bifunctional acid chloride, the monofunctional acid chloride, and the acid chloride reactive bifunctional compound and the equivalents to be used were changed to those listed in Table 1.

[Table 1]

| | Bifunctional acid chloride | | Acid chloride reactive bifunctional compound | | | | | | Monofunctional acid chloride | |
|---|---|---|---|---|---|---|---|---|---|---|
| | Structure 1 | % by mole | Structure 1 | % by mole | Structure 2 | % by mole | Structure 3 | % by mole | Structure | % by mole |
| A-1 | Isophthaloyl dichloride | 50 | JEFFAMINE D-400 | 50 | - | - | - | - | Methacryloyl chloride | 10 |
| A-2 | Isophthaloyl dichloride | 50 | JEFFAMINE D-400 | 30 | 2-Methyl-1,5-diaminopentane- | 20 | - | - | Methacryloyl chloride | 15 |
| A-3 | Isophthaloyl dichloride | 50 | JEFFAMINE D-400 | 40 | 2-Methyl-1,5-diaminopentane | 10 | - | - | Methacryloyl chloride | 15 |
| A-4 | 4,4'-Oxybis (benzoylchloride) | 50 | JEFFAMINE D-400 | 50 | - | - | - | - | - | - |
| A-5 | 4,4'-Oxybis (benzoylchloride) | 50 | JEFFAMINE D-400 | 30 | BLEMMER GLM | 20 | - | - | - | - |
| A-6 | 4,4'-Oxybis (benzoylchloride) | 50 | Piperazine | 30 | BLEMMER GLM | 10 | EO1 | 10 | - | - |
| A-7 | 4,4'-Oxybis (benzoylchloride) | 50 | Bis[2-(3-aminopropoxy)ethyl ether | 25 | BLEMMER GLM | 25 | - | - | - | - |
| A-8 | 4,4'-Oxybis (benzoylchloride) | 50 | 1,12-Diaminododecane | 25 | BLEMMER GLM | 25 | - | - | - | - |
| A-9 | 1,3-Benzenedisulfonyl chloride | 50 | JEFFAMINE D-400 | 50 | - | - | - | - | Methacryloyl chloride | 15 |
| A-10 | Bis(4-chlorosulfonylphenyl) methane | 50 | JEFFAMINE D-400 | 50 | - | - | - | - | Methacryloyl chloride | 15 |
| A-11 | 4,4-Oxybis (benzenesulfonylchloride) | 50 | JEFFAMINE D-400 | 50 | - | - | - | - | Methacryloyl chloride | 15 |
| A-12 | Isophthaloyl dichloride | 50 | Polyethylene glycol 400 | 13 | BLEMMER GLM | 25 | DURANOL T5651 | 12 | - | - |

(continued)

| | Bifunctional acid chloride | | Acid chloride reactive bifunctional compound | | | | | | Monofunctional acid chloride | |
|---|---|---|---|---|---|---|---|---|---|---|
| | Structure 1 | % by mole | Structure 1 | % by mole | Structure 2 | % by mole | Structure 3 | % by mole | Structure | % by mole |
| A-13 | 4,4'-Oxybis (benzoylchloride) | 50 | EO2 | 20 | DURANOL T5651 | 30 | - | - | Methacryloyl chloride | 15 |

Each compound listed in Table 1 is as follows.

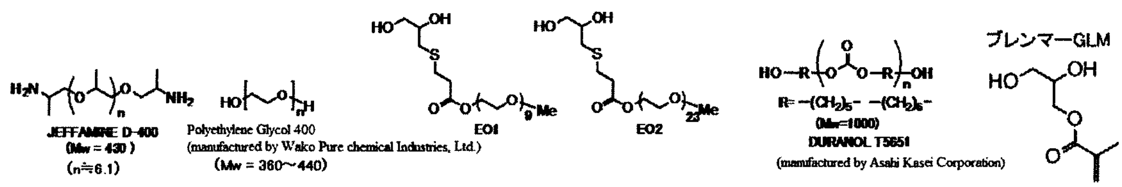
JEFFAMINE D-400 (Mw = 430) (n≒6.1)
Polyethylene Glycol 400 (manufactured by Wako Pure chemical Industries, Ltd.) (Mw = 360~440)
EO1
EO2
R= $-(CH_2)_5-$ $-(CH_2)_6-$ (Mw=1000)
DURANOL T5651 (manufactured by Asahi Kasei Corporation)
ブレンマー−GLM

(Synthesis Example 14: synthesis of specific polymer A-14)

A specific polymer A-14 was synthesized according to the following reaction scheme.

4.24 g (20.88 mmol) of isophthaloyl dichloride as bifunctional acid chloride, 0.44 g (4.18 mmol) of methacryloyl chloride (initial additive) as monofunctional acid chloride, 25 mg of 2,2,6,6-tetramethylpiperidine-1-oxyl (TEMPO), and 30.2 g of N,N-dimethylacetamide (DMAc) were added to a 200 mL three-neck flask, and the solution was stirred in an ice water bath. A mixed solution of 7.18 g (16.70 mmol) of JEFFAMINE D-400 (manufactured by Huntsman Corporation), 1.08 g (4.18 mmol) of 2,2-bis(3-amino-4-hydroxyphenyl)propane, 4.65 g (45.93 mmol) of trimethylamine, and 10.0 g of DMAc, as an acid chloride reactive bifunctional compound, was prepared in a dropping funnel, and the mixed solution was added dropwise to the three-neck flask such that the temperature of the reaction solution was set to 10°C or lower. The solution was stirred at 10°C or lower for 1 hour, 0.85 g (8.35 mmol) of triethylamine and 0.87 g (8.35 mmol) of methacryloyl chloride were added to the solution, and then the solution was further stirred at 60°C for 2 hours. 1.0 g of methanol was added thereto, the solution was further stirred at 60°C for 1 hour, and the reaction solution was cooled to room temperature. As the result of dropwise addition of the obtained reaction solution to 1000 g of distilled water, precipitation occurred. The obtained precipitation was recovered by removing the supernatant and washed with distilled water, and the obtained solid was dissolved in 40 g of 1-methoxy-2-propanol. After the remaining moisture was distilled off under reduced pressure, the amount of 1-methoxy-2-propanol was adjusted such that the solid content was set to 20%. A solution of a specific polymer A-14 in 1-methoxy-2-propanol was obtained by performing the above-described operation.

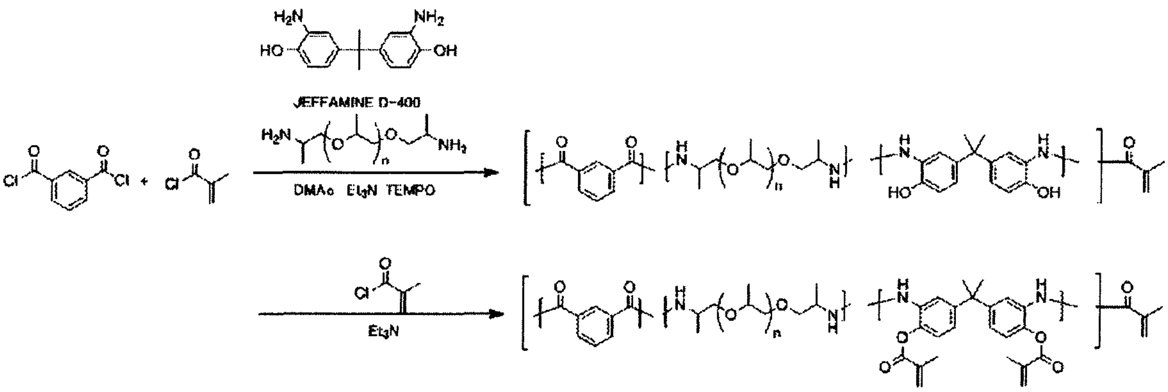


(Synthesis Examples 15 and 16: synthesis of specific polymers A-15 and A-16)

Solutions of specific polymers A-15 and A-16 in 1-methoxy-2-propanol were obtained in the same manner as in Synthesis Example 14 except that the types of the bifunctional acid chloride, the monofunctional acid chloride, and the acid chloride reactive bifunctional compound and the equivalents to be used were changed to those listed in Table 2.

[Table 2]

| | Bifunctional acid chloride | | Acid chloride reactive bifunctional compound | | | | Monofunctional acid chloride (initial additive | |
|---|---|---|---|---|---|---|---|---|
| | Structure 1 | % by mole | Structure 1 | % by mole | Structure 2 | % by mole | Structure | % by mole |
| A-14 | Isophthaloyl dichloride | 50 | JEFFAMINE D-400 | 40 | 2,2-Bis(3-amino-4-hydroxyphenyl) propane | 10 | Methacryloyl chloride | 10 |
| A-15 | Isophthaloyl dichloride | 50 | JEFFAMINE D-400 | 35 | Bis(4-amino-3-hydroxyphenyl) | 15 | Methacryloyl chloride | 10 |
| A-16 | 1,3-Benzenedisulfonyl chloride | 50 | JEFFAMINE D-400 | 40 | 2,2-Bis(3-amino-4-hydroxyphenyl)-hexafluoropropane | 10 | - | - |

(Synthesis Example 17: synthesis of specific polymer A-17)

A specific polymer A-17 was synthesized according to the following reaction scheme.

36.0 g (60.0 mmol) of JEFFAMINE ED-600 (manufactured by Huntsman Corporation), 10.12 g (100.0 mmol) of triethylamine, and 80.0 g of DMAc were added, as an acid chloride reactive bifunctional compound, to a 300 mL three-neck flask, and the solution was stirred at room temperature. A mixed solution of 7.11 g (35.0 mmol) of isophthaloyl dichloride as bifunctional acid chloride, 3.80 g (15.0 mmol) of 2,6-naphthoyl dichloride, and 40.7 g of DMAc was prepared in a dropping funnel, and the mixed solution was added dropwise to the three-neck flask such that the temperature of the reaction solution was set to 30°C or lower. The solution was stirred at room temperature for 1 hour, a mixed solution of 3.10 g (20.0 mmol) of 2-methacryloyloxyethyl isocyanate as isocyanate for sealing a terminal, 25 mg of TEMPO, and 20.0 g of DMAc was added dropwise to the solution, the solution was further stirred at 60°C for 1 hour, 1.0 g of methanol was added thereto, and the resulting solution was further stirred at 60°C for 1 hour. As the result of dropwise addition of the obtained reaction solution to 2000 g of distilled water after the reaction solution was cooled to room temperature, precipitation occurred. The obtained precipitation was recovered by removing the supernatant and washed with distilled water, and the obtained solid was dissolved in 140 g of 1-methoxy-2-propanol. After the remaining moisture was distilled off under reduced pressure, the amount of 1-methoxy-2-propanol was adjusted such that the solid content was set to 20%. A solution of a specific polymer A-19 in 1-methoxy-2-propanol was obtained by performing the above-described operation.

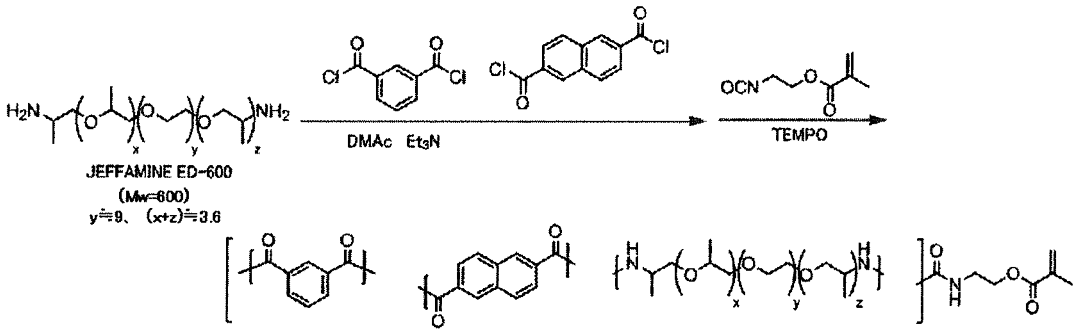


(Synthesis Examples 18 to 21: synthesis of specific polymers A-18 to A-21)

Solutions of specific polymers A-18 to A-21 in 1-methoxy-2-propanol were obtained in the same manner as in Synthesis Example 17 except that the types of the bifunctional acid chloride, the acid chloride reactive bifunctional compound, and the isocyanate for sealing a terminal and the equivalents to be used were changed to those listed in Table 3.

[Table 3]

| | Bifunctional acid chloride | | | | Acid chloride reactive bifunctional compound | | | | Isocyanate for sealing terminal | |
|---|---|---|---|---|---|---|---|---|---|---|
| | Structure 1 | % by mole | Structure 2 | % by mole | Structure 1 | % by mole | Structure 2 | % by mole | Structure | % by mole |
| A-17 | Isophthaloyl dichloride | 35 | 2,6-Naphthoyl dichloride | 15 | JEFFAMINE ED-600 | 60 | - | - | 2-Methacryloyloxyethyl isocyanate | 20 |
| A-18 | Cyclohexane-1,4-dicarbonyl dichloride | 50 | - | - | JEFFAMINE D-400 | 42 | 1,8-Diaminooctane | 18 | 2-Methacryloyloxyethyl isocyanate | 20 |
| A-19 | 4,4'-Oxybis (benzoylchloride) | 50 | - | - | JEFFAMINE D-400 | 60 | - | - | 2-Methacryloyloxyethyl isocyanate | 20 |
| A-20 | 1,3-Benzenedisulfonyl chloride | 50 | - | - | JEFFAMINE D-400 | 48 | 2-Methyl-1,5-diaminoentane | 12 | 2-(2-Methacryloyloxyethoxy) ethyl isocyanate | 20 |
| A-21 | 1,3-Benzenedisulfonyl chloride | 50 | - | - | JEFFAMINE ED-600 | 48 | 2-Methyl-1,5-diaminopentane | 12 | 2-Methacryloyloxyethyl isocyanate | 20 |

(Synthesis Example 22: synthesis of specific polymer A-22)

A specific polymer A-22 was synthesized according to the following reaction scheme.

3.09g (7.71 mmol) of polyethylene glycol 400 (manufactured by Wako Pure Chemical Industries, Ltd.), 3.09 g (19.28 mmol) of BLEMMER GLM (manufactured by NOF CORPORATION), and 11.57 g (11.57 mmol) of DURANOL T5651 (manufactured by Asahi Kasei Corporation) were added, as an isocyanate reactive bifunctional compound, to a 300 mL of three-neck flask, 25 mg of TEMPO and 37.5 g of 2-butanone were further added thereto, and the solution was stirred at room temperature. Further, 7.26 g (38.56 mmol) of m-xylylene diisocyanate and 78.6 mg of NEOSTANN U-600 (manufactured by Nitto Kasei Co., Ltd.) were added thereto, and the solution was heated to 65°C and stirred for 1.5 hours. 1.25 g of methanol was added thereto, the solution was further stirred for 1 hour, and the reaction solution was cooled at room temperature. After 2-butanone was distilled off under reduced pressure, 1-methoxy-2-propanol was added such that the solid content was set to 20% by mass. A solution of a specific polymer A-22 in 1-methoxy-2-propanol was obtained by performing the above-described operation.

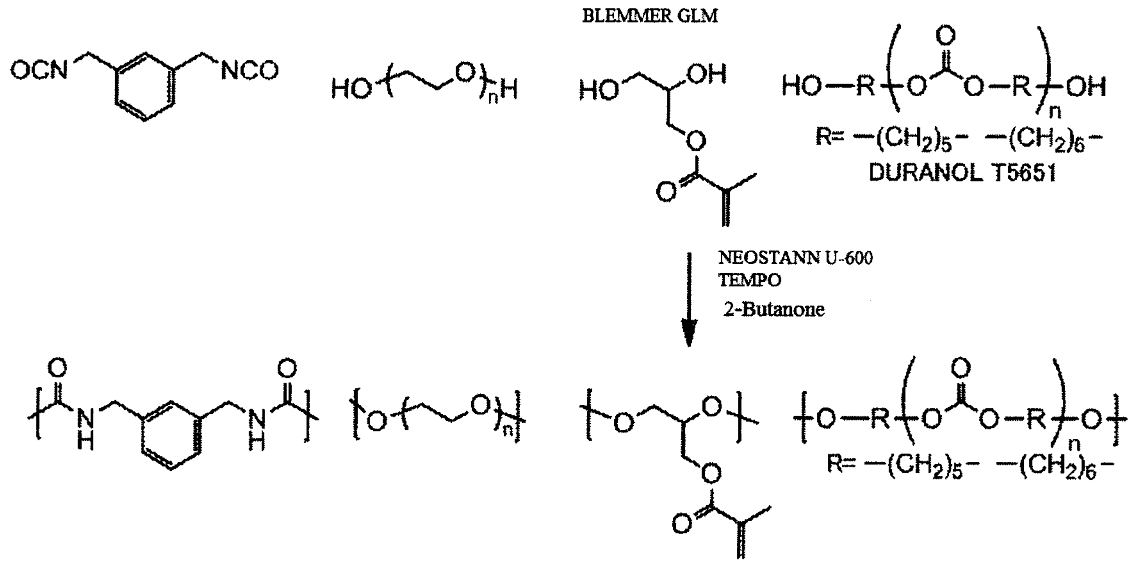


(Synthesis Example 23: synthesis of specific polymer A-23)

A specific polymer A-23 was synthesized according to the following reaction scheme.

7.38 g (7.38 mmol) of polypropylene glycol 1000 (manufactured by Wako Pure Chemical Industries, Ltd.), 2.56 g (15.98 mmol) of BLEMMER GLM (manufactured by NOF CORPORATION), and 7.38 g (7.38 mmol) of DURANOL T5651 (manufactured by Asahi Kasei Corporation) were added, as an isocyanate reactive bifunctional compound, to a 300 mL of three-neck flask, 25 mg of TEMPO and 37.5 g of 2-butanone were further added thereto, and the solution was stirred at room temperature. Further, 7.69 g (30.74 mmol) of diphenylmethane diisocyanate and 78.6 mg of NEOSTANN U-600 (manufactured by Nitto Kasei Co., Ltd.) were added thereto, and the solution was heated to 65°C and stirred for 1.5 hours. 1.25 g of methanol was added thereto, the solution was further stirred for 1 hour, and the reaction solution was cooled at room temperature. After 2-butanone was distilled off under reduced pressure, 1-methoxy-2-propanol was added such that the solid content was set to 20% by mass. A solution of a specific polymer A-23 in 1-methoxy-2-propanol was obtained by performing the above-described operation.

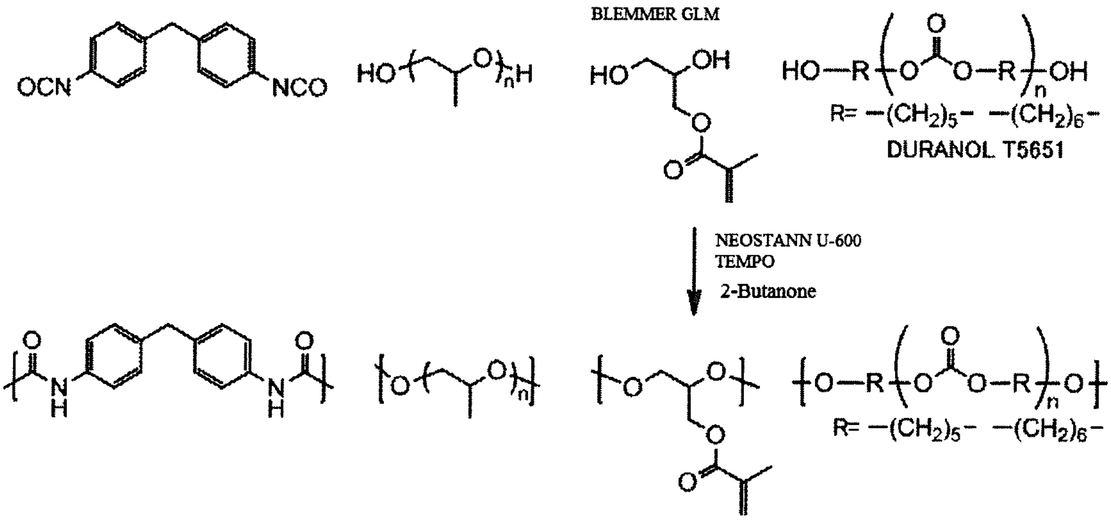


(Synthesis Example 24: synthesis of specific polymer A-24)

A specific polymer A-24 was synthesized according to the following reaction scheme.

8.52 g (34.05 mmol) of diphenylmethane diisocyanate as bifunctional isocyanate, 25 mg of TEMPO, and 37.5 g of DMAc were added to a 300 mL three-neck flask, and the solution was stirred at 60°C. A mixed solution of 2.18 g (13.63 mmol) of BLEMMER GLM (manufactured by NOF CORPORATION), 10.22 g (10.22 mmol) of DURANOL T5651 (manufactured by Asahi Kasei Corporation), and 12.5 g of DMAc was added thereto, as an isocyanate reactive bifunctional compound, and the solution was stirred at 60°C for 3 hours. The temperature of the reaction solution was returned to room temperature, a mixed solution of 4.09 g (10.21 mmol) of JEFFAMINE D-400 (manufactured by Huntsman Corporation) and 12.5 g of DMAc was added dropwise to the reaction solution, as an isocyanate reactive bifunctional compound, and the resulting solution was stirred at room temperature for 1 hour. 1.5 g of methanol was added thereto, the solution was further stirred for 1 hour, and the obtained reaction solution was added dropwise to 2000 g of distilled water. As the result, precipitation occurred. The obtained precipitation was recovered by removing the supernatant and washed with distilled water, and the obtained solid was dissolved in 100 g of 1-methoxy-2-propanol. After the remaining moisture was distilled off under reduced pressure, the amount of 1-methoxy-2-propanol was adjusted such that the solid content was set to 20%. A solution of a specific polymer A-24 in 1-methoxy-2-propanol was obtained by performing the above-described operation.

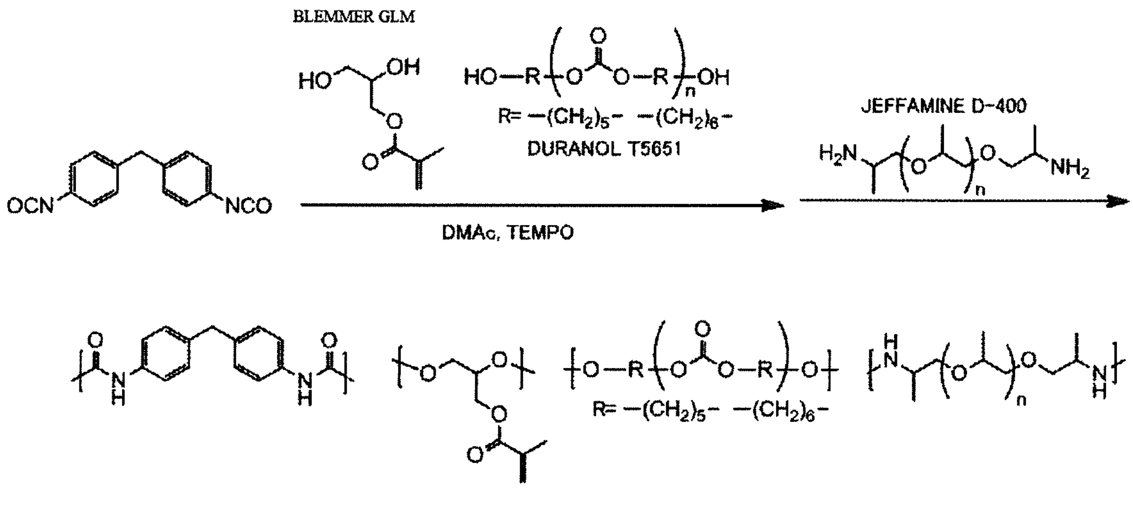


(Synthesis Example 25: synthesis of specific polymer A-25)

A specific polymer A-25 was synthesized according to the following reaction scheme.

6.48 g (25.91 mmol) of diphenylmethane diisocyanate as bifunctional isocyanate, 25 mg of TEMPO, and 37.5 g of DMAc were added to a 300 mL three-neck flask, and the solution was stirred at 60°C. A mixed solution of 12.95 g

(12.95 mmol) of DURANOL T5651 (manufactured by Asahi Kasei Corporation) and 12.5 g of DMAc was added thereto, as an isocyanate reactive bifunctional compound, and the solution was stirred at 60°C for 3 hours. The temperature of the reaction solution was returned to room temperature, 0.80 g (5.18 mmol) 2-methacryloyloxyethyl isocyanate was added to the reaction solution, as monofunctional isocyanate, a mixed solution of 5.57 g (12.95 mmol) of JEFFAMINE D-400 (manufactured by Huntsman Corporation) and 12.5 g of DMAc was added dropwise to the reaction solution, as an isocyanate reactive bifunctional compound, and the resulting solution was stirred at room temperature for 1 hour. 1.5 g of methanol was added thereto, the solution was further stirred for 1 hour, and the obtained reaction solution was added dropwise to 2000 g of distilled water. As the result, precipitation occurred. The obtained precipitation was recovered by removing the supernatant and washed with distilled water, and the obtained solid was dissolved in 105 g of 1-methoxy-2-propanol. After the remaining moisture was distilled off under reduced pressure, the amount of 1-methoxy-2-propanol was adjusted such that the solid content was set to 20%. A solution of a specific polymer A-25 in 1-methoxy-2-propanol was obtained by performing the above-described operation.

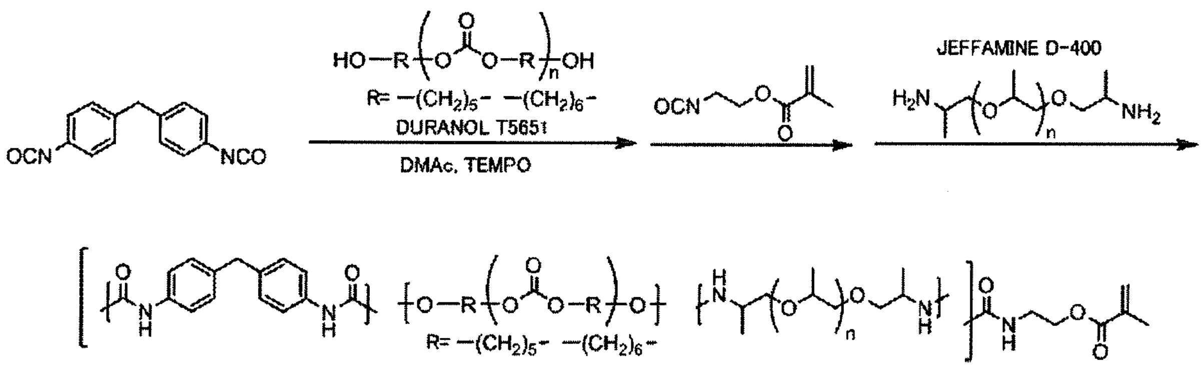


(Synthesis Example 26: synthesis of specific polymer A-26)

A solution of a specific polymer A-26 in 1-methoxy-2-propanol was obtained in the same manner as in Synthesis Example 25 except that the type of the bifunctional diisocyanate and the type of monofunctional isocyanate in Synthesis Example 25 were respectively changed to isophorone diisocyanate and 2-acryloyloxyethyl isocyanate, but the equivalent was set to be the same as that in Synthesis Example 25.

(Synthesis Example 27: synthesis of specific polymer A-27)

A specific polymer A-27 was synthesized according to the following reaction scheme.

4.36 g (20 mmol) of a pyromellitic anhydride, 8.60 g (20 mmol) of JEFFAMINE D-400 (manufactured by Huntsman Corporation), 0.22 g (2.5 mmol) of crotonic acid, 0.20 g (2.5 mmol) of pyridine, 30 g of N-methylpyrrolidone, and 10 g of toluene were added to a 200 mL three-neck flask provided with a Dean-Stark tube, and the solution was stirred at room temperature for 1 hour, heated at 180°C for 3 hours, and refluxed. As the result of dropwise addition of the obtained reaction solution to 1000 g of distilled water, precipitation occurred. The obtained precipitation was recovered by removing the supernatant and washed with distilled water, and the obtained solid was dissolved in 53 g of 1-methoxy-2-propanol. After the remaining moisture was distilled off under reduced pressure, the amount of 1-methoxy-2-propanol was adjusted such that the solid content was set to 20%. A solution of a specific polymer A-27 in 1-methoxy-2-propanol was obtained by performing the above-described operation.

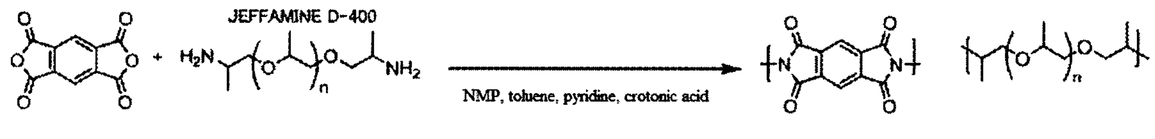


(Synthesis Example 28: synthesis of specific polymer A-28)

A specific polymer A-28 was synthesized according to the following reaction scheme.

13.09 g (60 mmol) of a pyromellitic anhydride, 21.50 g (50 mmol) of JEFFAMINE D-400 (manufactured by Huntsman Corporation), 0.54 g (6.25 mmol) of crotonic acid, 0.49 g (6.25 mmol) of pyridine, 75 g of N-methylpyrrolidone, and 25 g of toluene were added to a 200 mL three-neck flask provided with a Dean-Stark tube, and the solution was stirred at room temperature for 1 hour, heated at 180°C for 3 hours, and refluxed. After the reaction temperature was

decreased to 90°C, 2.60 g (20 mmol) of 2-hydroxyethyl methacrylate and 25 mg of TEMPO were added to the reaction solution, and the reaction solution was stirred at 90°C for 1 hour. In addition, 3.55 g (25 mmol) of glycidyl methacrylate and 0.37 g (1.75 mmol) of tetraethylammonium bromide were added thereto, and the reaction solution was stirred at 90°C for 24 hours. As the result of dropwise addition of the obtained reaction solution to 1000 g of distilled water after the temperature of the reaction solution was returned to room temperature, precipitation occurred. The obtained precipitation was recovered by removing the supernatant and washed with distilled water, and the obtained solid was dissolved in 140g of 1-methoxy-2-propanol, and then 25 mg of TEMPO was added thereto. After the remaining moisture was distilled off under reduced pressure, the amount of 1-methoxy-2-propanol was adjusted such that the solid content was set to 20%. A solution of a specific polymer A-28 in 1-methoxy-2-propanol was obtained by performing the above-described operation.

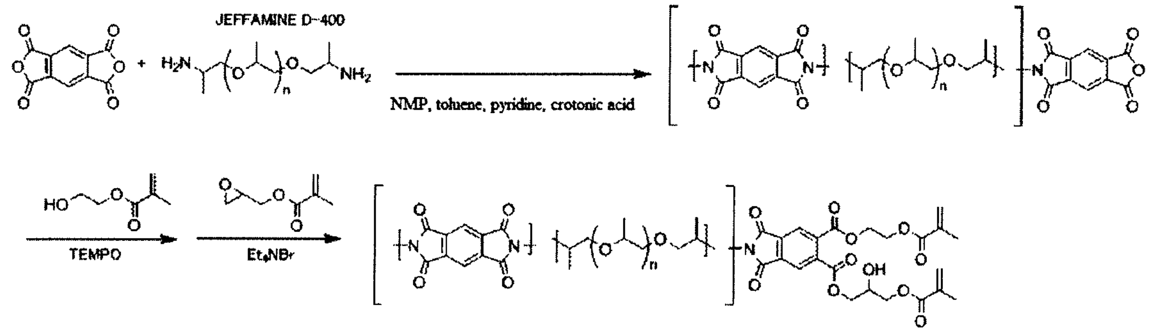


(Synthesis Example 29: synthesis of specific polymer A-29)

A solution of a specific polymer A-32 in 1-methoxy-2-propanol was obtained in the same manner as in Synthesis Example 28 except that the type of the pyromellitic anhydride in Synthesis Example 28 was changed to 4,4'-oxydiphthalic anhydride, but the equivalent was set to be the same as that in Synthesis Example 28.

(Synthesis Example 30: synthesis of specific polymer A-30)

A specific polymer A-30 was synthesized according to the following reaction scheme.

13.09 g (60 mmol) of a pyromellitic anhydride, 21.50 g (50 mmol) of JEFFAMINE D-400 (manufactured by Huntsman Corporation), and 75 g of N-methylpyrrolidone were added to a 200 mL three-neck flask, and the solution was stirred at room temperature for 1 hour. After the reaction temperature was increased to 90°C, 2.60 g (20 mmol) of 2-hydroxyethyl methacrylate and 25 mg of TEMPO were added to the reaction solution, and the reaction solution was stirred at 90°C for 1 hour. In addition, 21.32 g (150 mmol) of glycidyl methacrylate and 2.21 g (10.5 mmol) of tetraethylammonium bromide were added thereto, and the reaction solution was stirred at 90°C for 24 hours. As the result of dropwise addition of the obtained reaction solution to 2000 g of distilled water after the temperature of the reaction solution was returned to room temperature, precipitation occurred. The obtained precipitation was recovered by removing the supernatant and washed with distilled water, and the obtained solid was dissolved in 220g of 1-methoxy-2-propanol, and then 25 mg of TEMPO was added thereto. After the remaining moisture was distilled off under reduced pressure, the amount of 1-methoxy-2-propanol was adjusted such that the solid content was set to 20%. A solution of a specific polymer A-30 in 1-methoxy-2-propanol was obtained by performing the above-described operation.

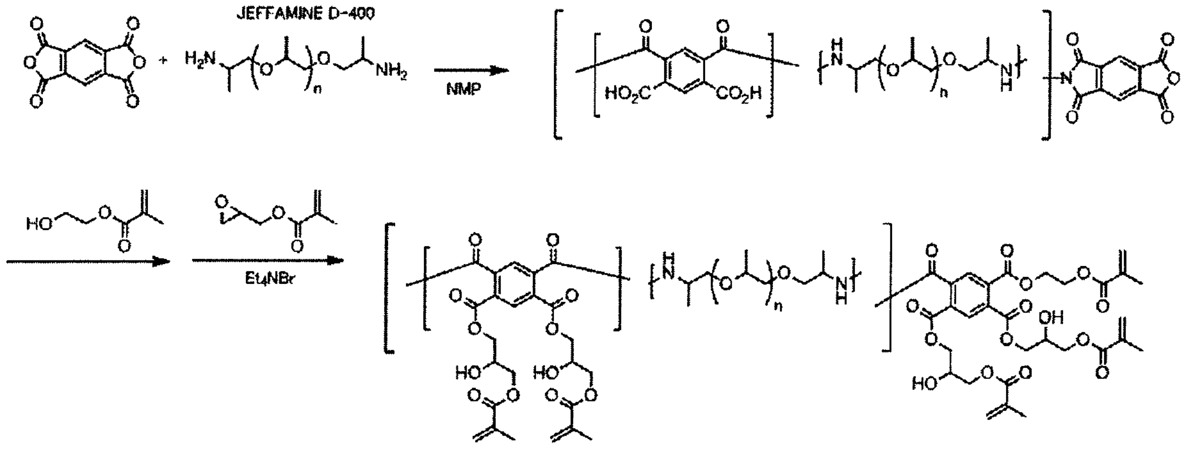


(Comparative Synthesis Examples 1 to 5: synthesis of comparative polymers R-1 to R-5)

Synthesis was performed by respectively setting an exemplary compound (2) described in JP2010-76436A to a comparative polymer R-1; an exemplary compound (2) described in JP2008-247000A to a comparative polymer R-2; an exemplary compound P-28 described in JP4401262B to a comparative polymer R-3; an exemplary compound (3-8) described in [Chem. 39] of JP2010-97189A to a comparative polymer R-4; and a binder polymer (1) described in [Chem. 30] of JP2012-206495A to a comparative polymer R-5.

(Comparative Synthesis Example 6: synthesis of comparative polymer R-6)

A solution of a comparative polymer R-6 in 1-methoxy-2-propanol was obtained in the same manner as in Synthesis Example 22 except that DURANOL T5651 in Synthesis Example 22 was changed to polyethylene glycol 1000 (manufactured by Wako Pure Chemical Industries, Ltd.).

DURANOL T5651 used in Synthesis Example 22 is polycarbonate having a molecular weight of 1000 and hydroxyl groups in both terminals, and the polyethylene glycol 1000 used in Comparative Synthesis Example 6 is polyethylene glycol having a molecular weight of 1000 and hydroxyl groups in both terminals. Therefore, the comparative polymer R-6 is the same polymer as the specific polymer A-22 except that the polycarbonate structure of the specific polymer A-22 is replaced with a polyethylene glycol structure. Further, the content of the carbamate group and the content of the radical polymerizable reactive group as the same as those in the specific polymer A-22.

The structures and the characteristics of the specific polymers (A-1) to (A-30) and the comparative polymers (R-1) to (R-6) used in the examples and the comparative examples are described below. Further, the following structural formulae show that any of the B components are bonded in adjacent to the A components. Further, a structure of a terminal group is described in a case of a polymer formed by introducing a radical polymerizable reactive group to a terminal of the polymer.

(A-1)

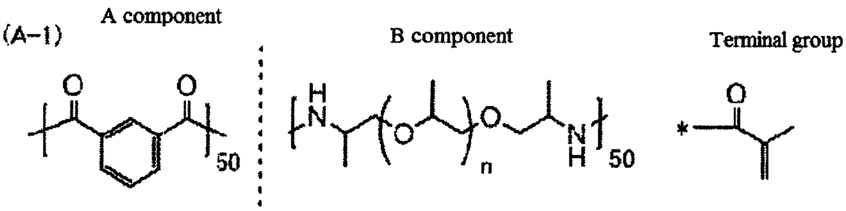


(A-2)

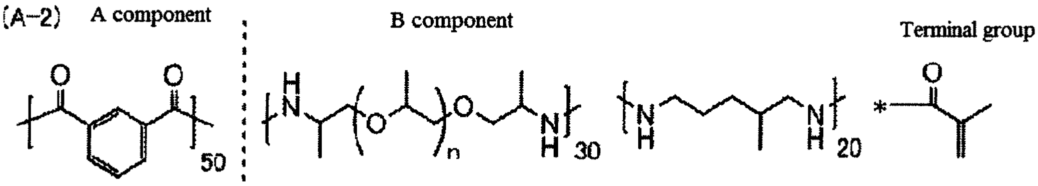

(A-3) A component

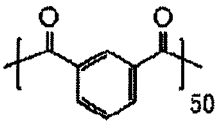

B component

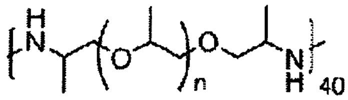

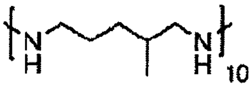

Terminal group

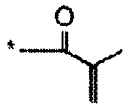

(A-4) A component

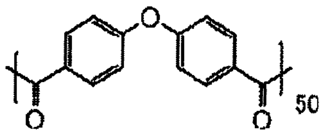

B component

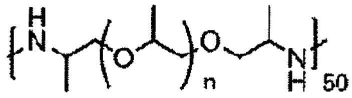

(A-5) A component

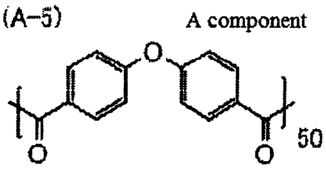

B component

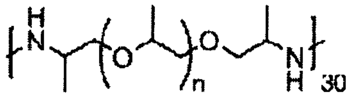

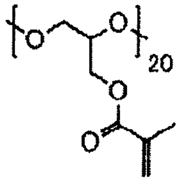

(A-6) A component

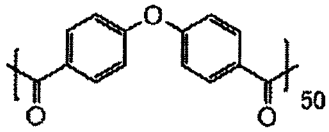

B component

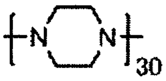

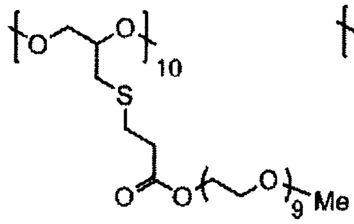

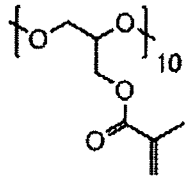

(A-7) A component

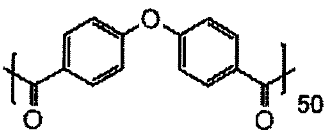

B component

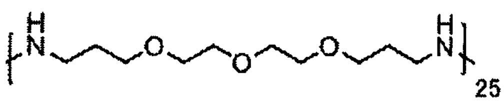

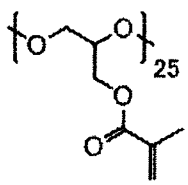

(A-8) A component

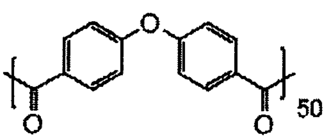

B component

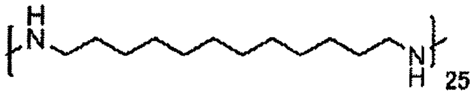

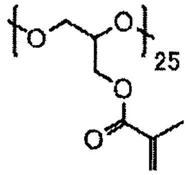

(A-9) A component B component Terminal group

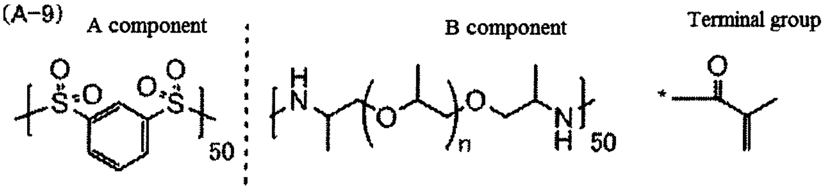

(A-10) A component B component Terminal group

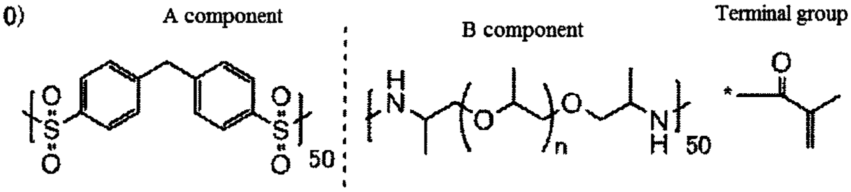

(A-11) A component B component Terminal group

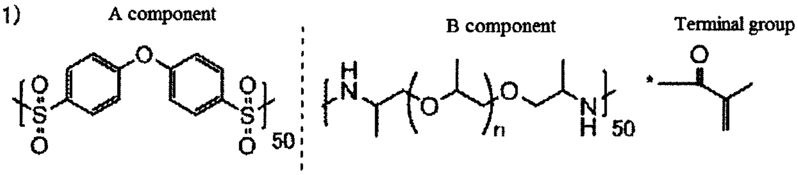

(A-12) A component B component

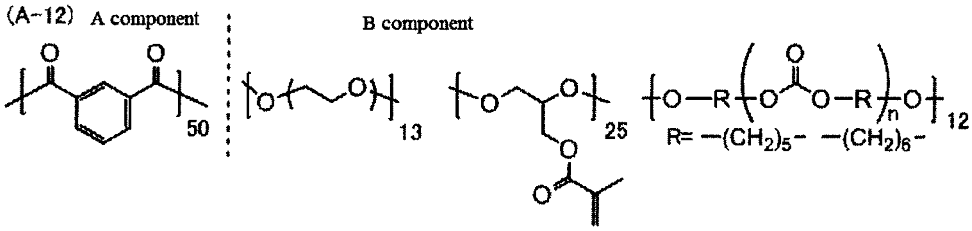

(A-13) A component B component Terminal group

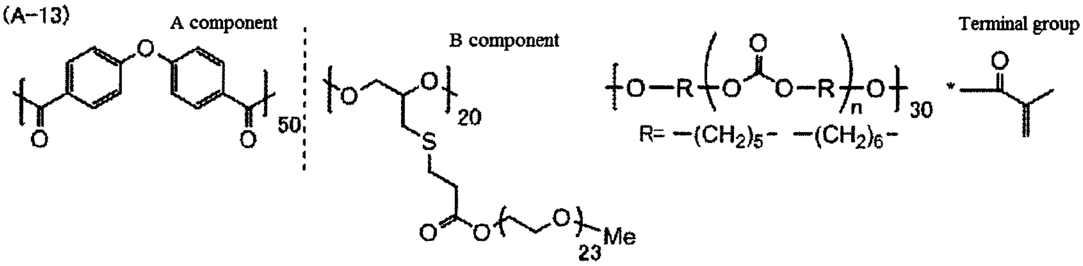

(A-14) A component B component Terminal group

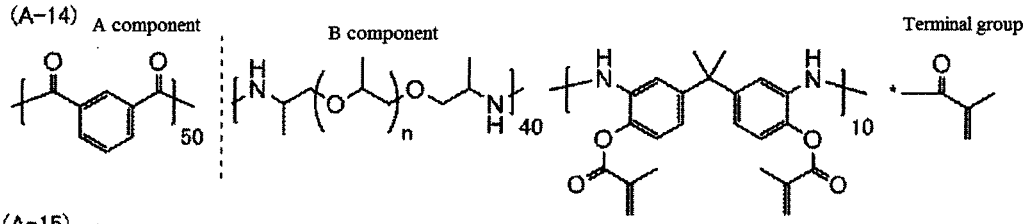

(A-15) A component B component Terminal group

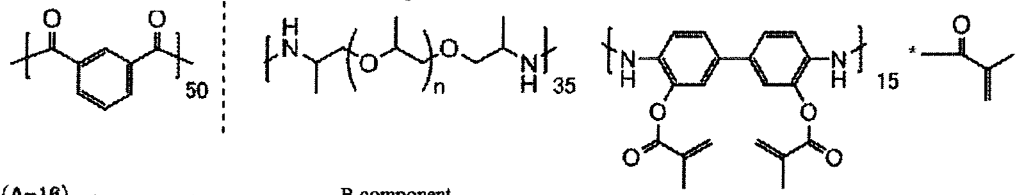

(A-16) A component B component

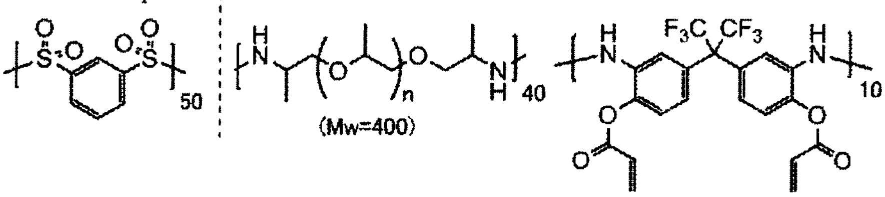


(A-17) A component B component Terminal group

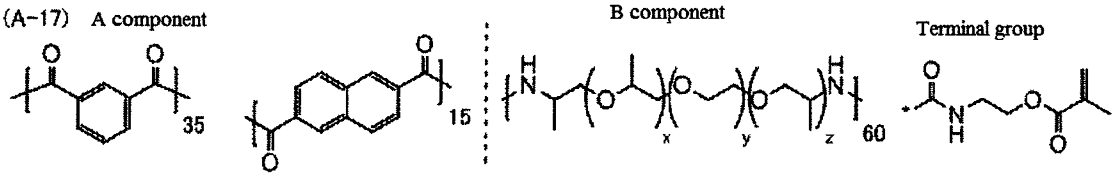

(A-18) A component B component Terminal group

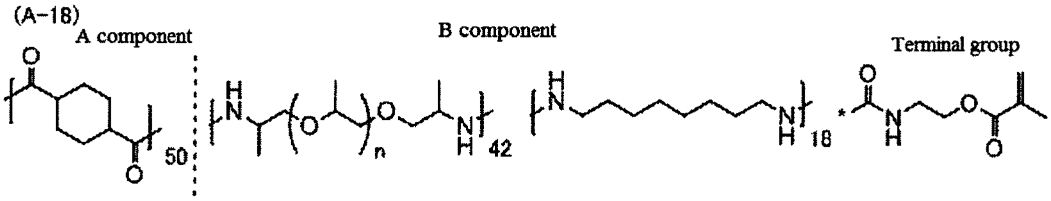

(A-19) A component B component Terminal group

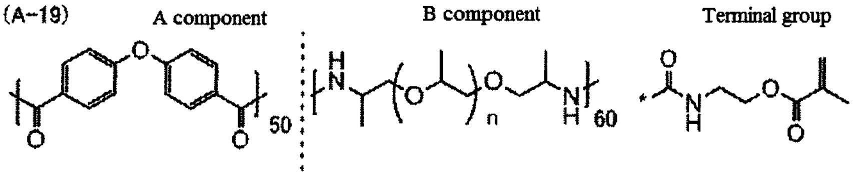

(A-20) A component B component Terminal group

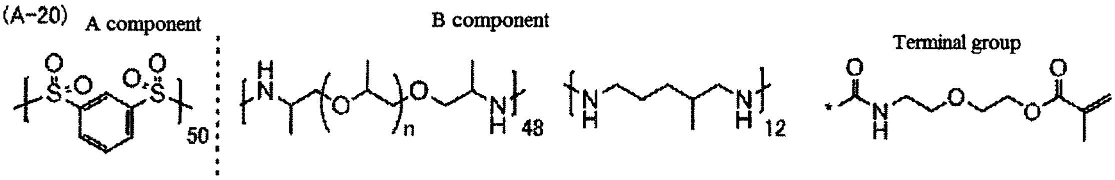

(A-21) A component B component Terminal group

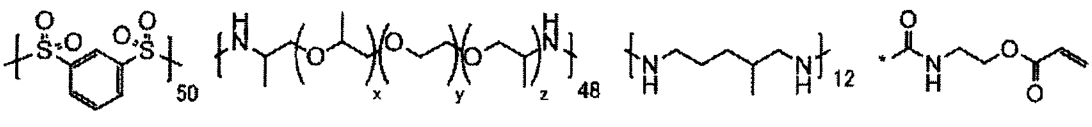

(A-22) A component B component

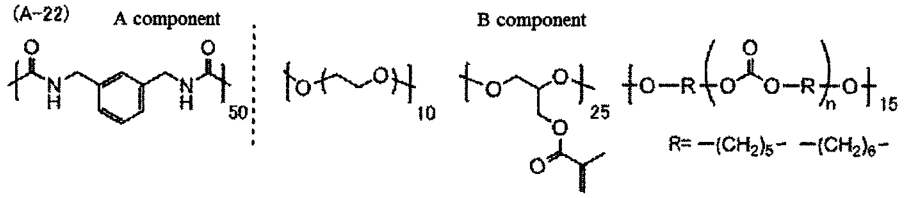

$R = -(CH_2)_5-$ $-(CH_2)_6-$

(A-23) A component B component

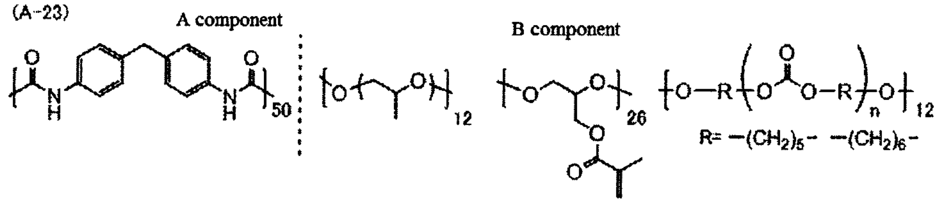

$R = -(CH_2)_5-$ $-(CH_2)_6-$

(A-24) A component B component

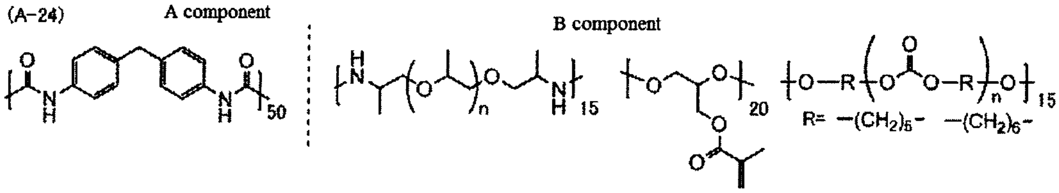

$R = -(CH_2)_5-$ $-(CH_2)_6-$

(A-25) A component B component Terminal group

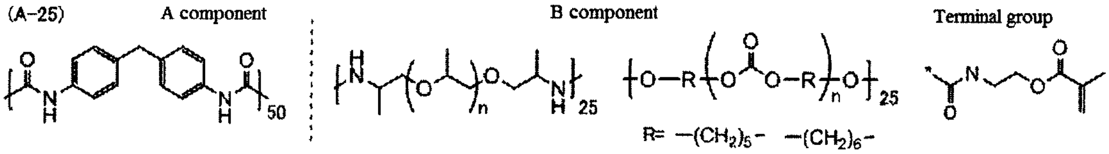

$R = -(CH_2)_5-$ $-(CH_2)_6-$

(A-26) A component B component Terminal group

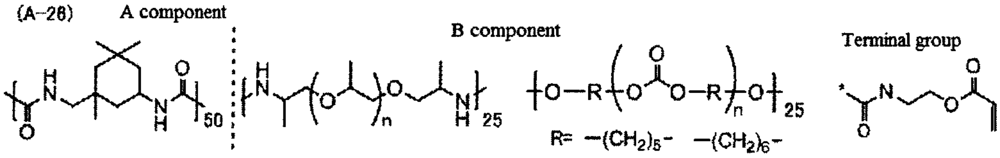

$R = -(CH_2)_5-$ $-(CH_2)_6-$

(A-27) A component B component

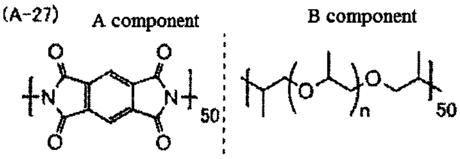

(A-28) A component B component Terminal group

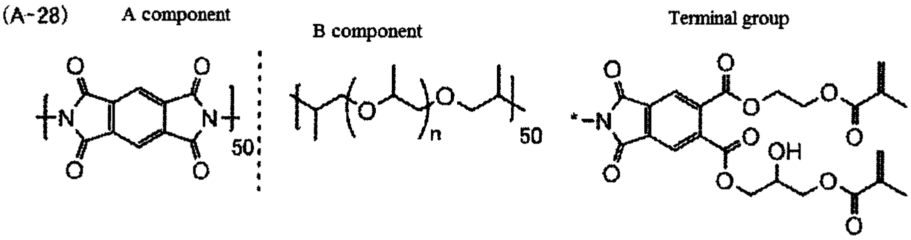

(A-29)

A component B component Terminal group

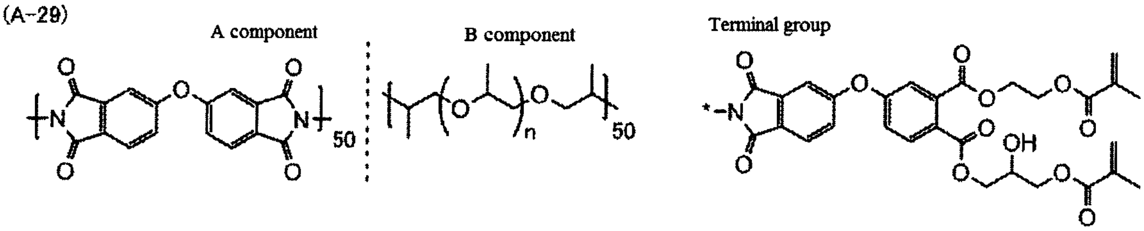

(A-30)

A component B component Terminal group

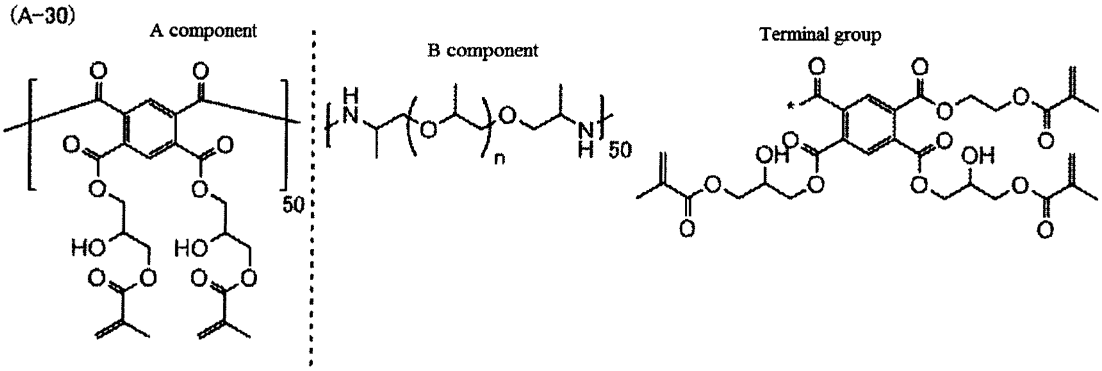

(R-1)

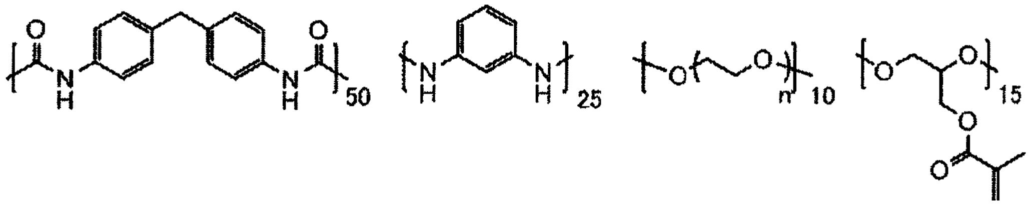

(R-2)

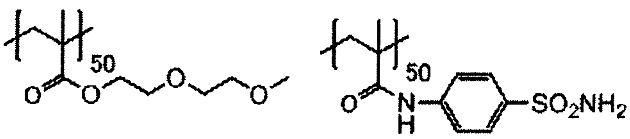

(R-3)

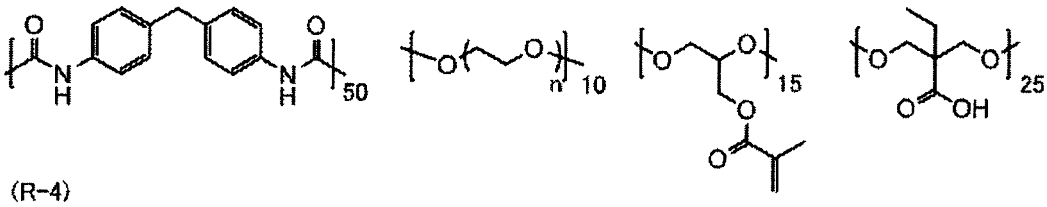

(R-4)

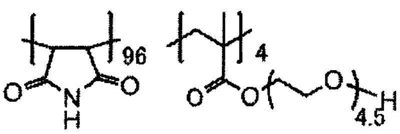

(R-5)

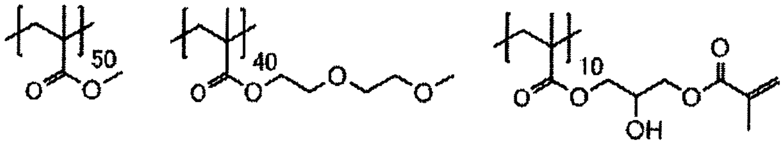

(R-6)

A component

B component

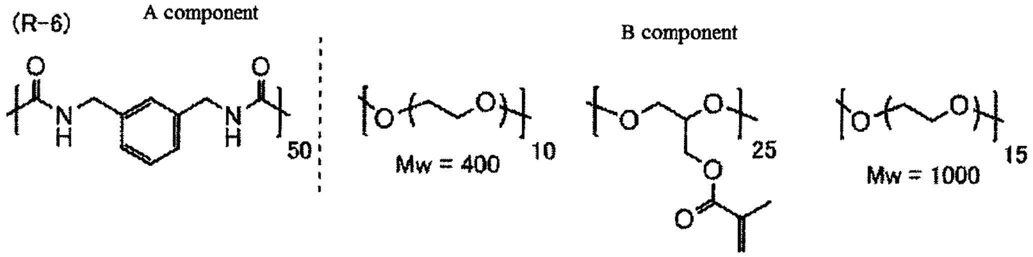


[Table 4]

| Polymer | Mass average molecular weight | Weight fraction of group represented by Formula (1) (%) | Amount of radical polymerizable reactive group (meq/g) | Acid value (mEq/g) | Group introduced into main chain of polymer |
|---|---|---|---|---|---|
| A-1 | 10000 | 69 | 0.35 | 0.05 > | Amide group |
| A-2 | 6800 | 60 | 0.66 | 0.05 > | Amide group |
| A-3 | 7800 | 65 | 0.58 | 0.05 > | Amide group |
| A-4 | 28000 | 61 | 0 | 0.05 > | Amide group |
| A-5 | 23000 | 44 | 0.73 | 0.05 > | Amide group |
| A-6 | 21000 | 19 | 0.48 | 0.05 > | Amide group |
| A-7 | 25000 | 23 | 1.21 | 0.05 > | Amide group |
| A-8 | 24000 | 21 | 1.24 | 0.05 > | Amide group |
| A-9 | 8200 | 61 | 0.46 | 0.05 > | Sulfonamide group |
| A-10 | 7500 | 54 | 0.40 | 0.05 > | Sulfonamide group |
| A-11 | 7100 | 53 | 0.40 | 0.05 > | Sulfonamide group |
| A-12 | 21000 | 19 | 0.90 | 0.05 > | Carbonate group |
| A-13 | 12000 | 31 | 0.23 | 0.05 > | Carbonate group |
| A-14 | 11000 | 59 | 1.11 | 0.05 > | Amide group |
| A-15 | 9000 | 55 | 1.57 | 0.05 > | Amide group |
| A-16 | 19000 | 51 | 0.65 | 0.05 > | Sulfonamide group |
| A-17 | 9000 | 74 | 0.43 | 0.05 > | Amide group |
| A-18 | 8500 | 61 | 0.65 | 0.05 > | Amide group |
| A-19 | 8200 | 60 | 0.50 | 0.05 > | Amide group |
| A-20 | 7800 | 56 | 0.55 | 0.05 > | Sulfonamide group |
| A-21 | 9200 | 66 | 0.46 | 0.05 > | Sulfonamide group |
| A-22 | 9500 | 12 | 0.77 | 0.05 > | Carbonate group |
| A-23 | 11000 | 29 | 0.64 | 0.05 > | Carbonate group |

(continued)

| Polymer | Mass average molecular weight | Weight fraction of group represented by Formula (1) (%) | Amount of radical polymerizable reactive group (meq/g) | Acid value (mEq/g) | Group introduced into main chain of polymer |
|---|---|---|---|---|---|
| A-24 | 24000 | 17 | 0.54 | 0.05 > | Carbonate group |
| A-25 | 10000 | 22 | 0.50 | 0.05 > | Carbonate group |
| A-26 | 5900 | 22 | 0.52 | 0.05 > | Carbonate group |
| A-27 | 12000 | 61 | 0 | 0.05 > | Imide group |
| A-28 | 7900 | 52 | 1.05 | 0.05 > | Imide group |
| A-29 | 8200 | 45 | 0.91 | 0.05 > | Imide group |
| A-30 | 7700 | 37 | 2.58 | 0.05 > | Amide group |
| R-1 | 50000 | 34.9 | 0.54 | 0.05 > | - |
| R-2 | 140000 | - | 0.00 | 0.05 > | - |
| R-3 | 70000 | 43.7 | 0.45 | 0.74 | - |
| R-4 | 89000 | - | 0.00 | 0.05 > | - |
| R-5 | 70000 | 50.8 | 0.07 | 0.05 > | - |
| R-6 | 9500 | 57 | 0.77 | 0.05 > | - |

[Examples 1 to 45 and Comparative Examples 1 to 11]

1. Preparation of planographic printing plate precursor A

<Preparation of support>

In order to remove rolling oil on a surface of an aluminum plate (Material JIS A 1050) having a thickness of 0.3 mm, a degreasing treatment was performed using a 10 mass% sodium aluminate aqueous solution at 50°C for 30 seconds, the aluminum surface was grains using three bundle nylon brushes having a diameter of 0.3 mm and a pumice water suspension (specific gravity of 1.1 g/cm$^3$) having a median diameter of 25 μm and then sufficiently washed with water. This aluminum plate was immersed in a 25 mass% sodium hydroxide aqueous solution at 45°C for 9 seconds, etched, washed with water, and further immersed in a 20 mass% nitric acid aqueous solution at 60°C for 20 seconds, and then washed with water. The etching amount of the grained surface at this time was approximately 3 g/m$^2$.

Next, an electrochemical roughening treatment was continuously performed using an AC voltage of 60 Hz. As the electrolytic solution, a 1 mass% nitric acid aqueous solution (including 0.5% by mass of aluminum ions) was used at a liquid temperature of 50°C. Using a trapezoidal rectangular waveform having a time TP, until the current value reached a peak from zero, of 0.8 msec and the duty ratio of 1:1 as an AC power source waveform, the electrochemical surface-roughening treatment was performed using a carbon electrode as a counter electrode. As an auxiliary anode, ferrite was used. The current density was 30 A/dm$^2$ as the peak current value, and 5% of the current flowing from the power source was separated to an auxiliary anode. The electric quantity in the nitric acid electrolysis was 175 C/dm$^2$ in a case where the aluminum plate was an anode. Thereafter, washing with water using a spray was performed.

Next, an electrochemical roughening treatment was performed according to the same method as the method for nitric acid electrolysis under the condition of an electric quantity of 50 C/dm$^2$ in a case where an aluminum plate is an anode in a 0.5 mass% hydrochloric acid aqueous solution (including 0.5% by mass of aluminum ions) and an electrolytic solution at a liquid temperature of 50°C. Subsequently, washing with water using a spray was performed.

Next, 2.5 g/m$^2$ of a DC anodized film was provided on this aluminum plate at a current density of 15 A/dm$^2$ using a 15 mass% nitric acid aqueous solution (including 0.5% by mass of aluminum ions), washed with water, and then dried, thereby preparing a support A.

Thereafter, in order to ensure hydrophilicity of the non-image area, a silicate treatment was performed on the support A at 60°C for 10 seconds using a 2.5 mass% No. 3 sodium silicate aqueous solution, and then the support was washed with water, thereby obtaining a support B. The adhesion amount of Si was 10 mg/m$^2$. The center line average

roughness (Ra) of the support which was measured using a needle having a diameter of 2 μm was 0.51 μm.

<Formation of undercoat layer>

The support B was coated with an undercoat layer coating solution (1) with the following composition such that the drying coating amount thereof was set to 20 mg/m$^2$, thereby preparing a support having an undercoat layer.

<Undercoat layer coating solution (1)>

| | |
|---|---|
| · Compound (1) for undercoat layer [the following structure] | 0.18 g |
| · Hydroxyethyl iminodiacetic acid | 0.10 g |
| · Methanol | 55.24 g |
| · Water | 6.15 g |

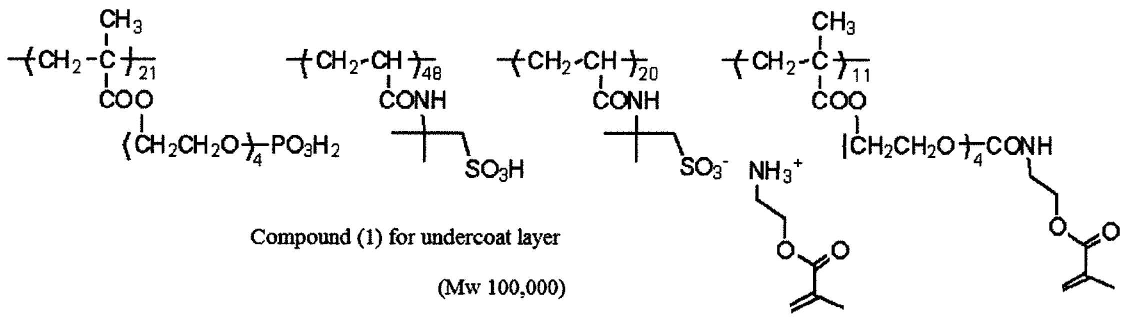

Compound (1) for undercoat layer

(Mw 100,000)

<Formation of image recording layer>

The undercoat layer was bar-coated with an image recording layer coating solution (1) with the following composition and dried in an oven at 100°C for 60 seconds, thereby forming an image recording layer having a drying coating amount of 1.0 g/m$^2$.

The image recording layer coating solution (1) was prepared by mixing the following photosensitive liquid and microgel liquid immediately before coating and stirring the solution.

<Photosensitive liquid>

| | |
|---|---|
| · Polymer of the present invention and comparative polymer [listed in Table A] | 0.240 g |
| · Polymerization initiator (1) [the following structure] | 0.245 g |
| · Cyanine coloring agent (X-1) [the following structure] | 0.023 g |
| · Borate compound | 0.010 g |
| TPB [the following structure] | (in case of addition) |
| · Polymerizable monomer [listed in Table A] | 0.192 g |
| · Low-molecular-weight hydrophilic compound | 0.062 g |
| Tris(2-hydroxyethyl)isocyanurate | |
| · Low-molecular-weight hydrophilic compound (1) [the following structure] | 0.050 g |
| · Sensitizing agent | 0.055 g |
| Phosphonium compound (1) [the following structure] | |
| · Sensitizing agent | 0.018 g |
| Benzyl-dimethyl-octylammonium-$PF_6$ salt | |
| · Sensitizing agent | 0.035 g |
| Ammonium group-containing polymer | |
| [the following structure, reduced specific viscosity of 44 ml/g] | |

(continued)

| | |
|---|---|
| · Fluorine-based surfactant (1) [the following structure] | 0.008 g |
| · 2-Butanone | 1.091 g |
| · 1-Methoxy-2-propanol | 8.609 g |

<Microgel liquid>

| | |
|---|---|
| · Microgel (1) | 2.640 g |
| · Distilled water | 2.425 g |

The structures of the polymerization initiator (1) used for the photosensitive liquid, the cyanine coloring agent (X-1), the TPB, the low-molecular-weight hydrophilic compound (1), the phosphonium compound (1), the ammonium group-containing polymer, and the fluorine-based surfactant (1) are as follows.

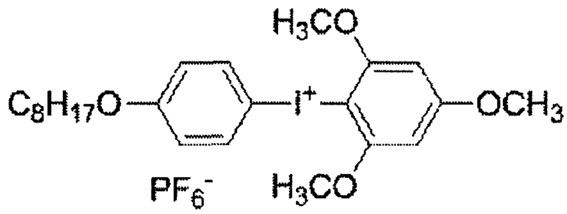

Polymerization initiator (1)

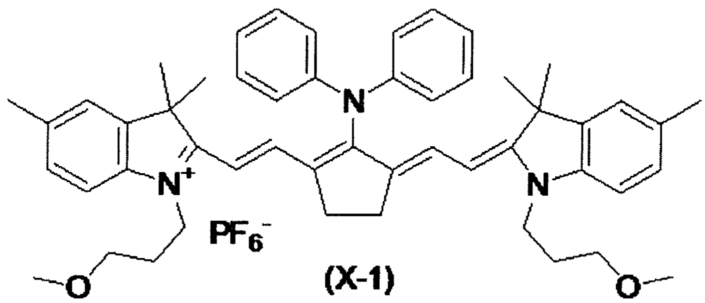

(X-1)

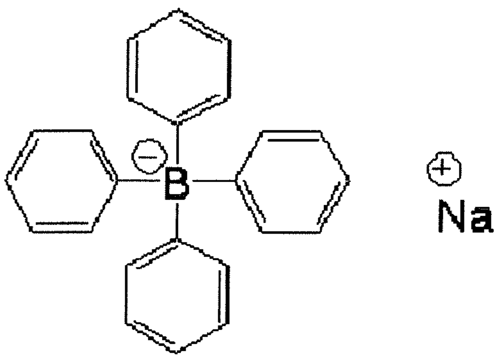

TPB

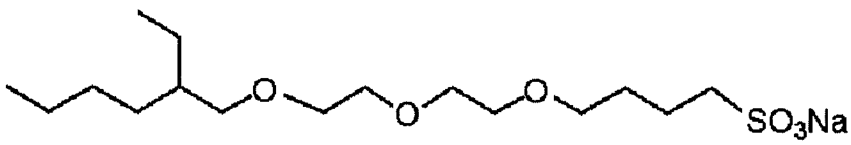

Low-molecular-weight hydrophilic compound (1)

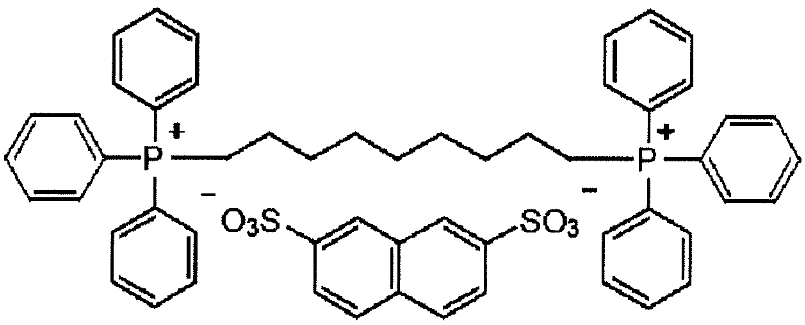

Phosphonium compound (1)

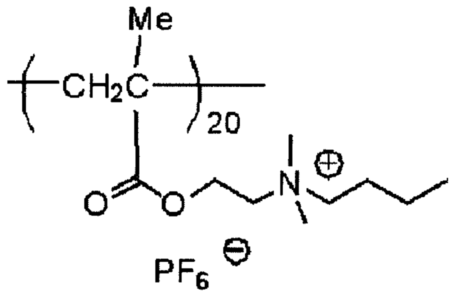

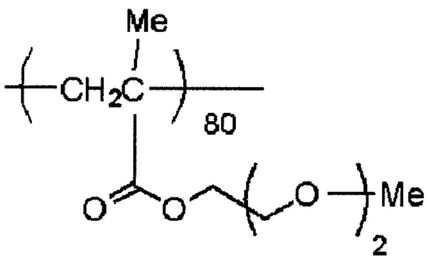

Ammonium group-containing polymer

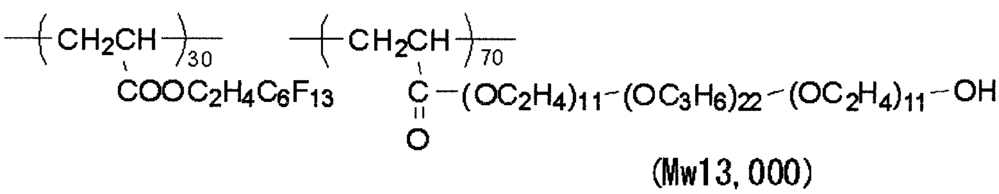

(Mw13, 000)

Fluorine-based surfactant (1)

Any of the following (M-1) to (M-4) was used as the polymerizable monomer. The trade names and the manufacturers of each monomer are described.

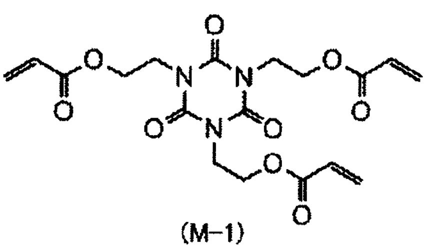

(M-1)

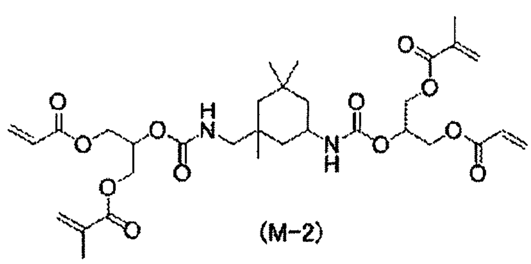

(M-2)

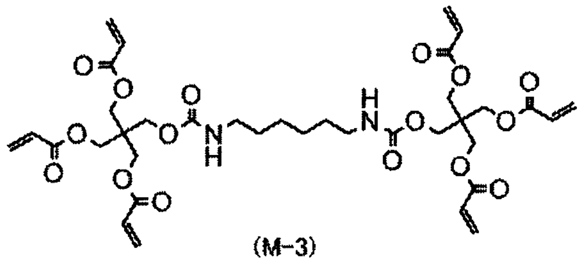

(M-3)

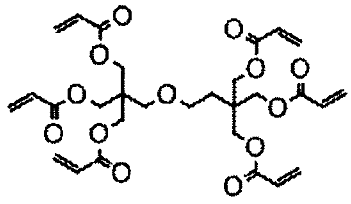

(M-4)

M-1: NK ESTER A-9300 (manufactured by Shin-Nakamura Chemical Co., Ltd.)
M-2: UA-306I (manufactured by KYOEISHA CHEMICALS Co., Ltd.)
M-3: UA-306H (manufactured by KYOEISHA CHEMICALS Co., Ltd.)
M-4: A-DPH (manufactured by Shin-Nakamura Chemical Co., Ltd.)

A method of preparing the microgel (1) used for the above-described microgel liquid is described below.

<Preparation of microgel (1)>

As oil phase components, 10 g of an adduct (TAKENATE D-110N, manufactured by Mitsui Chemical, Inc.) of trimethylolpropane and xylene diisocyanate, 3.15 g of pentaerythritol triacrylate (SR444, manufactured by Nippon Kayaku Co., Ltd.), and 0.1 g of an alkyl benzene sulfonate (PIONINE A-41C, manufactured by TAKEMOTO OIL & FAT Co., Ltd.) were dissolved in 17 g of ethyl acetate. As water phase components, 40 g of a 4 mass% aqueous solution of polyvinyl alcohol (PVA-205, manufactured by KURARAY CO., LTD.) was prepared. The oil phase components and the water phase components were mixed with each other and emulsified at 12,000 rpm for 10 minutes using a homogenizer. The obtained emulsion was added to 25 g of distilled water, and the resulting solution was stirred at room temperature for 30 minutes and stirred at 50°C for 3 hours. The microgel liquid obtained in this manner was diluted with distilled water such that the concentration of solid contents was set to 15% by mass, thereby preparing a microgel (1). The average particle diameter of the microgel measured by a light scattering method was 0.2 μm.

<Formation of protective layer>

The image recording layer was bar-coated with the following protective layer coating solution with the following composition and dried in an oven at 120°C for 60 seconds to form a protective layer having a drying coating amount of 0.15 g/m$^2$, thereby preparing planographic printing plate precursors A of Examples 1 to 45 and Comparative Examples 1 to 11.

<Protective layer coating solution>

| | |
|---|---|
| · Inorganic layered compound dispersion liquid (1) (described below) | 1.5 g |
| · 6 mass% aqueous solution containing polyvinyl alcohol (CKS50, manufactured by Nippon Synthetic Chemical Industry Co., Ltd., sulfonic acid-modified, saponification degree: 99% by mole or greater, degree of polymerization: 300) | 0.55 g |
| · 6 mass% aqueous solution containing polyvinyl alcohol (PVA-405, manufactured by KURARAY CO., LTD., saponification degree: 81.5% by mole, degree of polymerization: 500) | 0.03 g |
| · Polyoxyethylene lauryl ether (surfactant, EMALEX 710, manufactured by Nihon Emulsion Co., Ltd., 1 mass% aqueous solution) | 0.86 g |
| · Ion exchange water | 6.0 g |

A method of preparing the inorganic layered compound dispersion liquid (1) used for the protective layer coating solution is described below.

<Preparation of inorganic layered compound dispersion liquid (1)>

6.4 g of synthetic mica (SOMASIF ME-100, manufactured by CO-OP CHEMICAL CO., LTD.) was added to 193.6 g of ion exchange water and dispersed therein such that the average particle diameter (laser scattering method) was set to 3 μm using a homogenizer. The aspect ratio of the obtained dispersed particles was 100 or greater.

2. Evaluation of planographic printing plate precursors

The on-press developability, development scum, ink receptivity, and printing durability of the obtained planographic printing plate precursors were evaluated in the following manners.

(1) On-press developability

The planographic printing plate precursors were exposed in Luxel PLATESETTER T-6000III (manufactured by Fujifilm Corporation) equipped with an infrared semiconductor laser under conditions of external surface drum rotation speed of 1000 rpm, a laser output of 70%, and a resolution of 2,400 dpi. The exposed image had a solid image and a 50% halftone dot chart of an FM screen having dots with a diameter of 20 μm.

A printing press LITHRONE26 (manufactured by KOMORI Corporation) was attached to the plate cylinder without performing the development treatment on each of the exposed planographic printing plate precursors. Dampening water and ink were supplied using a standard automatic printing start method for LITHRONE26 using dampening water, in which the volume ratio of Ecolity-2 (manufactured by Fujifilm Corporation) to tap water was 2:98, and Values-G (N) black ink (manufactured by DIC Graphics Corporation), printing was performed on 100 sheets of Tokubishi Art (76.5 kg) paper (manufactured by Mitsubishi Paper Mills Limited) at a printing speed of 10000 sheets per hour.

The on-press development applied to the unexposed portion of the image recording layer on the printing press was completed, and the number of sheets of printing paper required until the ink was not transferred to the non-image area any more was measured and evaluated as the on-press developability. The on-press developability was excellent as the number of sheets of printing paper decreased. The results thereof are listed in Table A.

(2) Development scum

The printing press was stopped after the evaluation of on-press developability and before the evaluation of printing durability, and the printing plate after the 100-th sheet was printed was observed whether development scum (solid development removed material) was attached thereonto using a microscope (VHX-100, zoom lens VH-Z150, manufactured by Keyence Corporation) at a magnification of 500 times. The observation results were evaluated based on the following indication. A and B are in acceptable levels. The results are listed in Table A.

<Indication for evaluation of development scum>

A: Attached development scum was not found at all.
B: Development scum having a thickness of less than 50 μm was attached.
C: Development scum having a thickness of 50 μm or greater and less than 100 μm was attached.
D: Development scum having a thickness of 100 μm or greater was attached and the development scum was easily confirmed with naked eyes.

(3) Ink receptivity

After the printing was started, ink was gradually attached to the image recording layer (image area) and the ink density on the printing sheet was increased. The number of printed sheets at the time of the ink density being reached to the standard density of a printed material (number of sheets for ink receptivity) was measured as the ink receptivity. A case where the number of sheets for ink receptivity was 35 or less was evaluated as 5 points, a case where the number of sheets for ink receptivity was in a range of 36 to 50 was evaluated as 4 points, a case where the number of sheets for ink receptivity was in a range of 51 to 100 was evaluated as 3 points, a case where the number of sheets for ink receptivity was in a range of 101 to 150 was evaluated as 2 points, and a case where the number of sheets for ink receptivity was greater than 150 was evaluated as 1 point. The results are listed in Table A.

(4) Printing durability

The printing was further continued under the conditions described in the section of evaluation of on-press developability. Since the image recording layer was gradually worn out as the number of printed sheets increased, the ink density on the printed material decreased. The timing at which the value obtained by measuring the halftone dot area ratio of 50% halftone dots of the FM screen in the printed material using a gretag densitometer was smaller than the measured value of the 100-th printed sheet by 5% was regarded as completion of printing, and the number of print copies until the printing was completed was confirmed. The relative printing durability obtained by scoring a case where the number of print copies until the printing was completed was 50000 as 100 points was evaluated. As the number of points increases, this indicates that the printing durability is excellent. The evaluation results are listed in Table A.

$$\text{Relative printing durability} = (\text{number of print sheets of target precursor})/50{,}000 \times 100\ (\text{points})$$

[Table 5]

Table A

| | Planographic printing plate precursor | Polymer of present invention or comparative polymer | Borate compound | Polymerizable monomer | Printing durability (number of points) | On-press developability (number of sheets) | Development scum | Ink treceptivity (number of points) |
|---|---|---|---|---|---|---|---|---|
| Example 1 | A | A-1 | TPB | M-1 | 70 | 20 | A | 4 |
| Example 2 | A | A-2 | TPB | M-1 | 75 | 25 | A | 5 |
| Example 3 | A | A-3 | TPB | M-1 | 74 | 20 | A | 4 |
| Example 4 | A | A-4 | TPB | M-1 | 68 | 20 | A | 4 |
| Example 5 | A | A-5 | TPB | M-1 | 77 | 20 | A | 4 |
| Example 6 | A | A-6 | TPB | M-1 | 73 | 15 | A | 5 |
| Example 7 | A | A-7 | TPB | M-1 | 78 | 25 | A | 4 |
| Example 8 | A | A-8 | TPB | M-1 | 79 | 30 | A | 4 |
| Example 9 | A | A-9 | TPB | M-1 | 70 | 20 | A | 4 |
| Example 10 | A | A-10 | TPB | M-1 | 77 | 30 | A | 4 |
| Example 11 | A | A-11 | TPB | M-1 | 73 | 25 | A | 4 |
| Example 12 | A | A-12 | TPB | M-1 | 68 | 20 | A | 4 |
| Example 13 | A | A-13 | TPB | M-1 | 70 | 20 | A | 4 |

(continued)

| | Planographic printing plate precursor | Polymer of present invention or comparative polymer | Borate compound | Polymerizable monomer | Printing durability (number of points) | On-press developability (number of sheets) | Development scum | Ink treceptivity (number of points) |
|---|---|---|---|---|---|---|---|---|
| Example 14 | A | A-14 | TPB | M-1 | 81 | 30 | A | 4 |
| Example 15 | A | A-14 | TPB | M-2 | 84 | 30 | A | 4 |
| Example 16 | A | A-14 | TPB | M-3 | 85 | 30 | A | 4 |
| Example 17 | A | A-14 | TPB | M-4 | 79 | 30 | A | 4 |
| Example 18 | A | A-15 | TPB | M-1 | 80 | 30 | A | 4 |

[Table 6]

Continuation of Table A

| | | | | | | | | |
|---|---|---|---|---|---|---|---|---|
| Example 19 | A | A-16 | TPB | M-1 | 79 | 25 | A | 4 |
| Example 20 | A | A-17 | TPB | M-1 | 72 | 25 | A | 4 |
| Example 21 | A | A-18 | TPB | M-1 | 69 | 30 | A | 4 |
| Example 22 | A | A-19 | TPB | M-1 | 70 | 20 | A | 4 |
| Example 23 | A | A-20 | TPB | M-1 | 73 | 25 | A | 4 |
| Example 24 | A | A-20 | TPB | M-2 | 75 | 30 | A | 4 |
| Example 25 | A | A-20 | TPB | M-3 | 77 | 30 | A | 4 |
| Example 26 | A | A-20 | TPB | M-4 | 72 | 25 | A | 4 |
| Example 27 | A | A-21 | TPB | M-1 | 72 | 25 | A | 4 |
| Example 28 | A | A-22 | TPB | M-1 | 69 | 20 | A | 4 |
| Example 29 | A | A-23 | TPB | M-1 | 79 | 25 | A | 4 |
| Example 30 | A | A-24 | TPB | M-1 | 82 | 25 | A | 4 |
| Example 31 | A | A-24 | TPB | M-1 | 85 | 25 | A | 4 |
| Example 32 | A | A-24 | TPB | M-1 | 86 | 25 | A | 4 |
| Example 33 | A | A-24 | TPB | M-1 | 78 | 25 | A | 4 |
| Example 34 | A | A-25 | TPB | M-1 | 77 | 20 | A | 4 |
| Example 35 | A | A-26 | TPB | M-1 | 73 | 20 | A | 4 |
| Example 36 | A | A-27 | TPB | M-1 | 67 | 25 | A | 4 |
| Example 37 | A | A-28 | TPB | M-1 | 69 | 25 | A | 4 |
| Example 38 | A | A-29 | TPB | M-1 | 72 | 30 | A | 4 |
| Example 39 | A | A-29 | TPB | M-2 | 75 | 30 | A | 4 |
| Example 40 | A | A-29 | TPB | M-3 | 75 | 30 | A | 4 |
| Example 41 | A | A-29 | TPB | M-4 | 70 | 30 | A | 4 |
| Example 42 | A | A-30 | TPB | M-1 | 88 | 30 | A | 4 |

[Table 7]

Continuation of Table A

| | | | | | | | | |
|---|---|---|---|---|---|---|---|---|
| Comparative Example 1 | A | R-1 | TPB | M-1 | 62 | 35 | B | 3 |
| Comparative Example 2 | A | R-1 | TPB | M-2 | 64 | 35 | B | 3 |
| Comparative Example 3 | A | R-1 | TPB | M-3 | 64 | 35 | B | 3 |
| Comparative Example 4 | A | R-1 | TPB | M-4 | 59 | 35 | B | 3 |
| Comparative Example 5 | A | R-2 | TPB | M-1 | 45 | 90 | C | 2 |
| Comparative Example 6 | A | R-3 | TPB | M-1 | 65 | > 200 | D | 3 |
| Comparative Example 7 | A | R-4 | TPB | M-1 | 41 | 150 | C | 3 |
| Comparative Example 8 | A | R-5 | TPB | M-1 | 65 | 35 | A | 4 |

(continued)

| | | | | | | | | |
|---|---|---|---|---|---|---|---|---|
| Comparative Example 9 | A | R-6 | TPB | M-1 | 42 | 35 | B | 3 |
| Example 43 | A | A-20 | None | M-1 | 68 | 20 | A | 4 |
| Example 44 | A | A-25 | None | M-1 | 73 | 15 | A | 4 |
| Example 45 | A | A-29 | None | M-1 | 65 | 25 | A | 4 |
| Comparative Example 10 | A | R-1 | None | M-1 | 58 | 30 | B | 3 |
| Comparative Example 11 | A | R-5 | None | M-1 | 55 | 30 | A | 4 |

From the results listed in Table A, it was understood that the planographic printing plate precursor containing the polymer according to the present invention has excellent on-press developability, resistance to adhesion of development scum, ink receptivity, and printing durability, compared to the planographic printing plate precursors in the comparative examples which contain the comparative polymer.

That is, compared to the planographic printing plate precursors in the comparative examples which contain the comparative polymer R-1 having a urea bond and a urethane bond in the main chain, the comparative polymer R-2 having a sulfonamide group in the side chain, the comparative polymers R-3 and R-6 having a urethane bond in the main chain, and the comparative polymer R-4 having an imide bond in the side chain, the planographic printing plate precursor containing the polymer according to the present invention which has any group selected from a sulfonamide group, an amide group, an imide group and a carbonate group in the main chain has excellent on-press developability, resistance to adhesion of development scum, ink receptivity, and printing durability. Further, the planographic printing plate precursor containing the polymer according to the present invention has excellent printing durability and on-press developability even compared to the planographic printing plate precursor in the comparative example which contains the comparative polymer R-5 that is a known acrylic polymer so that the remarkable effects of the polymer according to the present invention can be recognized.

[Examples 46 to 61 and Comparative Examples 12 to 15]

1. Preparation of planographic printing plate precursor B

In the preparation of the above-described planographic printing plate precursor A, the plate was bar-coated with an image recording layer coating solution (2) with the following composition in place of the image recording layer coating solution (1) and dried in an oven at 70°C for 60 seconds to form an image recording layer having a drying coating amount of 0.6 g/$m^2$, thereby preparing a planographic printing plate precursor B. The planographic printing plate precursor B is a planographic printing plate precursor that does not include a protective layer.

<Image recording layer coating solution (2)>

| | |
|---|---|
| · Polymer of the present invention and comparative polymer [listed in Table B] | 0.450 g |
| · Cyanine coloring agent (X-1) [the structure shown above] | 0.020 g |
| · Polymerization initiator (1) [the structure shown above] | 0.245 g |
| · Borate compound | 0.010 g |
| TPB [the structure shown above] | (in case of addition) |
| · Polymer fine particle aqueous dispersion liquid (1) (22% by mass) [shown below] | 10.0 g |
| · Polymerizable monomer [listed in Table B] | 1.50 g |
| · Mercapto-3-triazole | 0.2 g |
| · n-Propanol | 55.0 g |
| · 2-Butanone | 17.0 g |

A method of preparing the polymer fine particle aqueous dispersion liquid (1) used for the above-described image recording layer coating solution (2) is described below.

<Preparation of polymer fine particle aqueous dispersion liquid (1)>

Nitrogen gas was introduced into a 1,000 ml four-necked flask equipped with a stirrer, a thermometer, a dropping funnel, a nitrogen introduction pipe, and a reflex condenser, deoxygenation was performed, 10 g of polyethylene glycol methyl ether methacrylate (PEGMA, average number of repeating units of ethylene glycol: 50), 200 g of distilled water, and 200 g of n-propanol were added thereto, and then the mixture was heated until the internal temperature thereof was set to 70°C. Next, a mixture of 10 g of styrene (St), 80 g of acrylonitrile (AN), and 0.8 g of 2,2'-azobisisobutyronitrile prepared in advance was added dropwise for 1 hour. After dropwise addition was finished, the reaction was allowed to be continued for 5 hours, 0.4 g of 2,2'-azobisisobutyronitrile was added thereto, and the mixture was heated until the internal temperature was set to 80°C. Subsequently, 0.5 g of 2,2'-azobisisobutyronitrile was added for 6 hours. The total degree of polymerization at the stage of the continued reaction for 20 hours was 98% or greater, and a polymer fine particle aqueous dispersion liquid (1) having PEGMA, St, and AN at a mass ratio of 10/10/80 was obtained. The particle size distribution of these polymer fine particles has a maximum value at 150 nm of the particle diameter.

Here, the particle size distribution was acquired by imaging an electron micrograph of a fine particle polymer, measuring the total number of 5,000 particle diameters of fine particles on the photograph, dividing the interval from the maximum value of the obtained measured value of the particle diameter to 0 into the logarithmic scale of 50, and plotting the appearance frequency of each particle diameter. Further, the particle diameter of a spherical particle having the same particle area as the particle area on the photograph was set to the particle diameter, as non-spherical particles.

2. Evaluation of planographic printing plate precursors

The on-press developability, the development scum, the ink receptivity, and the printing durability of the obtained planographic printing plate precursors were evaluated in the same manner as in Example 1. The evaluation results are listed in Table B.

[Table 8]

Table B

| | Planographic printing plate precursor | Polymer of present invention or comparative polymer | Borate compound | Polymerizable monomer | Printing durability (number of points) | On-press developability (number of sheets) | Development scum | Ink receptivi-ty (number of points) |
|---|---|---|---|---|---|---|---|---|
| Example 46 | B | A-5 | TPB | M-1 | 69 | 15 | A | 4 |
| Example 47 | B | A-5 | TPB | M-2 | 72 | 15 | A | 4 |
| Example 48 | B | A-5 | TPB | M-3 | 72 | 15 | A | 4 |
| Example 49 | B | A-5 | TPB | M-4 | 69 | 15 | A | 4 |
| Example 50 | B | A-10 | TPB | M-1 | 70 | 25 | A | 4 |
| Example 51 | B | A-20 | TPB | M-1 | 66 | 20 | A | 4 |
| Example 52 | B | A-25 | TPB | M-1 | 75 | 15 | A | 4 |
| Example 53 | B | A-29 | TPB | M-1 | 67 | 25 | A | 4 |
| Comparative Example 12 | B | R-1 | TPB | M-1 | 58 | 30 | B | 3 |
| Comparative Example 13 | B | R-5 | TPB | M-1 | 52 | 30 | A | 4 |
| Example 54 | B | A-5 | None | M-1 | 64 | 15 | A | 4 |
| Example 55 | B | A-5 | None | M-2 | 68 | 15 | A | 4 |
| Example 56 | B | A-5 | None | M-3 | 68 | 15 | A | 4 |
| Example 57 | B | A-5 | None | M-4 | 65 | 15 | A | 4 |
| Example 58 | B | A-10 | None | M-1 | 66 | 25 | A | 4 |
| Example 59 | B | A-20 | None | M-1 | 62 | 20 | A | 4 |
| Example 60 | B | A-25 | None | M-1 | 70 | 15 | A | 4 |
| Example 61 | B | A-29 | None | M-1 | 63 | 25 | A | 4 |
| Comparative Example 14 | B | R-1 | None | M-1 | 54 | 30 | B | 3 |

(continued)

| | Planographic printing plate precursor | Polymer of present invention or comparative polymer | Borate compound | Polymerizable monomer | Printing durability (number of points) | On-press developability (number of sheets) | Development scum | Ink receptivi-ty (number of points) |
|---|---|---|---|---|---|---|---|---|
| Comparative Example 15 | B | R-5 | None | M-1 | 40 | 25 | A | 4 |

From the results listed in Table B, it was understood that the planographic printing plate precursor according to the present invention has excellent on-press developability, resistance to adhesion of development scum, ink receptivity, and printing durability, compared to the planographic printing plate precursors of the comparative examples that contain comparative polymers.

That is, compared to the planographic printing plate precursor in the comparative example which contains the comparative polymer R-1 having a urea bond and a urethane bond in the main chain, the planographic printing plate precursor containing the polymer according to the present invention which has any group selected from a sulfonamide group, an amide group, an imide group and a carbonate group in the main chain has excellent on-press developability, resistance to adhesion of development scum, ink receptivity, and printing durability. Further, the planographic printing plate precursor containing the polymer according to the present invention has excellent printing durability and on-press developability even compared to the planographic printing plate precursor in the comparative example which contains the comparative polymer R-5 that is a known acrylic polymer so that the remarkable effects of the polymer according to the present invention can be recognized.

According to the present invention, it is possible to provide a planographic printing plate precursor and a plate-making method in which on-press developability, resistance to adhesion of development scum, ink receptivity, and printing durability are excellent.

The present invention has been described in detail with reference to specific embodiments, but various changes or modifications can be made without departing from the scope of the present invention and this is apparent to those skilled in the art.

## Claims

1. A planographic printing plate precursor comprising:

   a support; and
   an image recording layer on the support,
   wherein the image recording layer contains a polymer having any group selected from a sulfonamide group, an amide group, an imide group and a carbonate group in a main chain and having a group represented by the following Formula (1),

   (1) 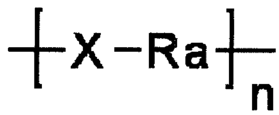

   wherein in the Formula (1), X represents a single bond or an oxygen atom, Ra represents an alkylene group having 6 to 40 carbon atoms in a case where X represents a single bond and Ra represents an alkylene group having 2 to 20 carbon atoms in a case where X represents an oxygen atom, and n represents an integer of 1 to 90.

2. The planographic printing plate precursor according to claim 1,
   wherein the polymer has the group represented by the Formula (1) in the main chain.

3. The planographic printing plate precursor according to claim 1 or 2,
   wherein the group represented by the Formula (1) is an oxyethylene group or an oxypropylene group.

4. The planographic printing plate precursor according to any one of claims 1 to 3,
   wherein the polymer is a polymer that further has a radical polymerizable reactive group.

5. The planographic printing plate precursor according to any one of claims 1 to 4,
   wherein a mass average molecular weight of the polymer is in a range of 3000 to 60000.

6. The planographic printing plate precursor according to any one of claims 1 to 5,
   wherein an acid value of the polymer is 0.05 mEq/g or less.

7. The planographic printing plate precursor according to any one of claims 1 to 6,
   wherein a proportion of the group represented by the Formula (1) in the polymer is in a range of 15% to 60% by mass.

**8.** The planographic printing plate precursor according to any one of claims 1 to 7, wherein the image recording layer further contains a polymerizable compound, a polymerization initiator, and an infrared-ray absorbent.

**9.** The planographic printing plate precursor according to any one of claims 1 to 8, wherein an unexposed portion of the image recording layer is removable by at least one of dampening water or printing ink.

**10.** A plate-making method comprising:

image-exposing the planographic printing plate precursor according to claim 9 using an infrared laser; and removing the unexposed portion of the image recording layer using at least one of dampening water or printing ink on a printing press.

**Patentansprüche**

**1.** Flachdruckplattenvorläufer, umfassend:

einen Träger; und
eine Bildaufzeichnungsschicht auf dem Träger,
worin die Bildaufzeichnungsschicht ein Polymer enthält, das irgendeine Gruppe, ausgewählt aus einer Sulfonamidgruppe, einer Amidgruppe, einer Imidgruppe und einer Carbonatgruppe, in einer Hauptkette aufweist und eine durch die folgende Formel (I) dargestellte Gruppe aufweist,

$$(1) \quad -\!\!\left[ X-Ra \right]_n\!\!-$$

worin in der Formel (1) X eine Einfachbindung oder ein Sauerstoffatom darstellt, Ra eine Alkylengruppe mit 6 bis 40 Kohlenstoffatomen darstellt, wenn X eine Einfachbindung darstellt, und Ra eine Alkylengruppe mit 2 bis 20 Kohlenstoffatomen darstellt, wenn X ein Sauerstoffatom darstellt, und n eine ganze Zahl von 1 bis 90 darstellt.

**2.** Flachdruckplattenvorläufer gemäß Anspruch 1, worin das Polymer die durch die Formel (1) dargestellte Gruppe in der Hauptkette aufweist.

**3.** Flachdruckplattenvorläufer gemäß Anspruch 1 oder 2, worin die durch die Formel (1) dargestellte Gruppe eine Oxyethylengruppe oder ein Oxypropylengruppe ist.

**4.** Flachdruckplattenvorläufer gemäß irgendeinem der Ansprüche 1 bis 3, worin das Polymer ein Polymer ist, das ferner eine radikalisch polymerisierbare, reaktive Gruppe aufweist.

**5.** Flachdruckplattenvorläufer gemäß irgendeinem der Ansprüche 1 bis 4, worin das massengemittelte Molekulargewicht des Polymers im Bereich von 3.000 bis 60.000 liegt.

**6.** Flachdruckplattenvorläufer gemäß irgendeinem der Ansprüche 1 bis 5, worin ein Säurewert des Polymers 0,05 mÄq/g oder weniger beträgt.

**7.** Flachdruckplattenvorläufer gemäß irgendeinem der Ansprüche 1 bis 6, worin der Anteil der durch die Formel (1) dargestellten Gruppe in dem Polymer von 15 bis 60 Masse-% beträgt.

**8.** Flachdruckplattenvorläufer gemäß irgendeinem der Ansprüche 1 bis 7, worin die Bildaufzeichnungsschicht ferner eine polymerisierbare Verbindung, einen Polymerisationsinitiator und einen Infrarotabsorber enthält.

**9.** Flachdruckplattenvorläufer gemäß irgendeinem der Ansprüche 1 bis 8, worin ein nicht-belichteter Bereich der Bildaufzeichnungsschicht durch zumindest eines von Anfeuchtwasser oder Drucktinte entfernt werden kann.

**10.** Plattenherstellungsverfahren, umfassend:

bildweises Belichten des Flachdruckplattenvorläufers gemäß Anspruch 9 unter Verwendung eines Infrarotlasers; und
Entfernen des nicht-belichteten Bereichs der Bildaufzeichnungsschicht unter Verwendung von zumindest einem von Anfeuchtwasser oder Drucktinte auf einer Druckpresse.

## Revendications

**1.** Précurseur de plaque d'impression planographique comprenant :

un support; et
une couche d'enregistrement d'image sur le support,
dans lequel la couche d'enregistrement d'image contient un polymère ayant un groupe quelconque choisi parmi un groupe sulfonamide, un groupe amide, un groupe imide et un groupe carbonate dans une chaîne principale et ayant un groupe représenté par la formule (1) suivante :

$$(1)\quad -\!\left[X-Ra\right]_{n}\!-$$

dans lequel dans la formule (1), X représente un liaison simple ou un atome d'oxygène, Ra représente un groupe alcylène ayant de 6 à 40 atomes de carbone dans un cas où X représente une liaison simple et Ra représente un groupe alcylène ayant de 2 à 20 atomes de carbone dans un cas où X représente un atome d'oxygène, et n représente un entier de 1 à 90.

**2.** Le précurseur de plaque d'impression planographique de la revendication 1,
dans lequel le polymère a le groupe représenté par la formule (1) dans la chaîne principale.

**3.** Le précurseur de plaque d'impression planographique de la revendication 1 ou 2,
dans lequel le groupe représenté par la formule (1) est un groupe oxyéthylène ou un groupe oxypropylène.

**4.** Le précurseur de plaque d'impression planographique de l'une quelconque des revendications 1 à 3,
dans lequel le polymère est un polymère qui a en outre un groupe réactif polymérisable par voie radicalaire.

**5.** Le précurseur de plaque d'impression planographique de l'une quelconque des revendications 1 à 4,
dans lequel un poids moléculaire moyen en masse du polymère est dans un domaine de 3000 à 60000.

**6.** Le précurseur de plaque d'impression planographique de l'une quelconque des revendications 1 à 5,
dans lequel un indice d'acidité du polymère est 0,05 mEq/g ou moins.

**7.** Le précurseur de plaque d'impression planographique de l'une quelconque des revendications 1 à 6,
dans lequel une proportion du groupe représenté par la formule (1) dans le polymère est dans un domaine de 15% à 60% en masse.

**8.** Le précurseur de plaque d'impression planographique de l'une quelconque des revendications 1 à 7,
dans lequel la couche d'enregistrement d'image contient en outre un compose polymérisable, un initiateur de polymérisation, et un absorbeur d'infrarouge.

**9.** Le précurseur de plaque d'impression planographique de l'une quelconque des revendications 1 à 8,
dans lequel une portion non exposée de la couche d'enregistrement d'image est amovible par au moins l'un d'une eau de mouillage ou d'une encre d'impression.

**10.** Procédé de préparation de plaque comprenant :

l'exposition à une image du précurseur de plaque d'impression planographique selon la revendication 9 en

utilisant un laser infrarouge ; et
le retrait de la portion non exposée de la couche d’enregistrement d’image en utilisant au moins l’un d’une eau de mouillage ou d’une encre d’impression sur une presse d’impression.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010076436 A
- JP 2008247000 A
- US 2011076621 A1
- EP 1564591 A2
- WO 2006059700 A
- JP 2011123219 A
- WO 2010126133 A
- WO 2010071100 A
- WO 2010150885 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP S4841708 B
- JP 51037193 A
- JP S5137193 A
- JP 2032293 B
- JP H0232293 B
- JP 2016765 B
- JP H0216765 B
- JP 2003344997 A
- JP 2006065210 A
- JP 58049860 B
- JP S5849860 B
- JP 56017654 B
- JP S5617654 B
- JP 62039417 B
- JP S6239417 B
- JP 62039418 B
- JP 2000250211 A
- JP 2007094138 A
- US 7153632 B
- JP 8505958 A
- JP H08505958 A
- JP 2007293221 A
- JP 2007293223 A
- EP 24629 B
- EP 107792 B
- US 4410621 A
- JP 5158230 A
- JP H05158230 A
- US 4069055 A
- JP 4365049 A
- JP H04365049 A
- US 4069056 A
- EP 104143 B
- US 20080311520 A
- JP 2150848 A
- JP H02150848 A
- JP 2008195018 A
- EP 370693 B
- EP 233567 B
- EP 297443 B
- EP 297442 B
- US 4933377 A
- US 4760013 A
- US 4734444 A
- US 2833827 A
- GE 2904626 B
- GE 3604580 B
- GE 3604581 B
- JP 2007206217 A
- JP 2001133969 A
- JP 2002023360 A
- JP 2002040638 A
- JP 2002278057 A
- JP 2007090850 A
- JP 5005005 A
- JP H055005 A
- JP 2001222101 A
- JP 2007276454 A
- JP 2009154525 A
- JP 2006297907 A
- JP 2007050660 A
- JP 2008284858 A
- JP 2009090645 A
- JP 2009208458 A
- JP 9123387 A
- JP H09123387 A
- JP 9131850 A
- JP H09131850 A
- JP 9171249 A
- JP H09171249 A
- JP 9171250 A

- JP H09171250 A
- EP 931647 B
- JP 2001277740 A
- JP 2001277742 A
- JP 62143044 A
- JP 62150242 A
- JP 9188685 A
- JP H09188685 A
- JP 9188686 A
- JP H09188686 A
- JP 9188710 A
- JP H09188710 A
- JP 2000131837 A
- JP 2002107916 A
- JP 2764769 B
- JP 2002116539 A
- JP 2005509192 A
- JP 2004310000 A
- JP 10282679 A
- JP H10282679 A
- JP 2304441 A
- JP H02304441 A
- JP 2005250216 A
- JP 2006259137 A
- JP 2005119273 A
- JP 5045885 A
- JP H0545885 A
- JP 6035174 A
- JP H0635174 A
- JP 4401262 B
- JP 2010097189 A
- JP 2012206495 A

**Non-patent literature cited in the description**


- **S. I. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh, Proc. Conf. Rad. Curing ASIA,* October 1988, 478
- Dye Handbook. 1970
- *Research Disclosure,* January 1992
- **KUNZ ; MARTIN.** *Rad Tech' 98. Proceeding,* 19 April 1998
- Polymer Dictionary. 2005, 683, , 684